# EUROPÄISCHE PATENTSCHRIFT

(11) **EP 0 793 699 B1**
(45) Veröffentlichungstag und Bekanntmachung des Hinweises auf die Patenterteilung: **07.10.1998**
(21) Anmeldenummer: 95940229.8
(22) Anmeldetag: 22.11.1995
(51) Int. Cl.: C09K 11/06, H05B 33/14, C07C 13/72, C08G 79/00

(54) **HETEROSPIROVERBINDUNGEN UND IHRE VERWENDUNG ALS ELEKTROLUMINESZENZMATERIALIEN**
HETEROSPIRO-COMPOUNDS AND THEIR USE AS ELECTROLUMINESCENT MATERIALS
COMPOSES HETEROSPIRO ET LEUR UTILISATION COMME MATERIAUX ELECTROLUMINESCENTS

(30) Priorität: 25.11.1994 DE 4442050
(43) Veröffentlichungstag der Anmeldung: 10.09.1997
(73) Patentinhaber: HOECHST AKTIENGESELLSCHAFT, 65929 Frankfurt am Main (DE)
(72) Erfinder: KREUDER, Willi, D-55126 Mainz (DE); LUPO, Donald, D-60316 Frankfurt am Main (DE); SALBECK, Josef, D-65779 Kelkheim (DE); SCHENK, Hermann, D-65719 Hofheim (DE); STEHLIN, Thomas, D-65830 Kriftel (DE)
(86) Internationale Anmeldenummer: EP9504593
(87) Internationale Veröffentlichungsnummer: WO9617035

(56) Entgegenhaltungen:
- EP-A- 0 676 461

## Beschreibung

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeigeelementen, wie Glühlampen, Gasentladungslampen und nicht selbstleuchtenden Flüssigkristallanzeigeelementen, sind bereits seit einiger Zeit Elektrolumineszenz(EL)materialien und -vorrichtungen, wie lichtemittierende Dioden (LED), bekannt.

Elektrolumineszenzmaterialien sind Stoffe, die befähigt sind, beim Anlegen eines elektrischen Feldes Licht abzustrahlen. Das physikalische Modell zur Beschreibung dieses Effektes basiert auf der strahlenden Rekombination von Elektronen und Elektronenlücken ("Löchern"). Bei lichtemittierenden Dioden werden die Ladungsträger über die Kathode bzw. Anode in das Elektrolumineszenzmaterial injiziert.
Elektrolumineszenzvorrichtungen enthalten ein Lumineszenzmaterial als lichtemitterende Schicht.
Allgemein sind Elektrolumineszenzmaterialien und -vorrichtungen beispielsweise beschrieben in Ullmann's Encyclopedia of Industrial Chemistry, Vol A9, 5th Ed. VCH Verlag 1987 und der dort zitierten Literatur.
Neben anorganischen Stoffen, wie ZnS/Mn oder GaAs, sind auch organische Verbindungen als EL-Materialien bekannt geworden.

Eine Beschreibung von EL-Vorrichtungen, die niedermolekulare, organische EL-Materialien enthalten, findet sich beispielsweise in US-A-4,539,507.

Nachteile dieser niedermolekularen, organischen Materialien sind beispielsweise die ungenügenden Filmbildungseigenschaften und eine ausgeprägte Tendenz zur Kristallisation.

In jüngerer Zeit sind auch Polymere als EL-Materialien beschrieben worden (siehe z.B. WO-A 90/13148). Jedoch ist die Lichtausbeute (Quanteneffizienz) bei diesen Stoffen beträchtlich geringer als bei den niedermolekularen Verbindungen.

Wünschenswert war es, EL-Materialien zu finden, die gute Lichtausbeuten zeigen, gleichzeitig zu dünnen homogenen Filmen verarbeitbar sind und eine geringe Kristallisationsneigung aufweisen.

Es wurde nun überraschend gefunden, daß sich Heterospiroverbindungen in hervorragender Weise als EL-Materialien eignen. Spiroverbindungen sind gekennzeichnet durch mindestens ein vierbindiges Spiroatom, das zwei Ringsysteme miteinander verknüpft. Dies wird im Handbook of Chemistry and Physics, 62nd ed. (1981-2), S. C-23 bis 25 ausgeführt.

Einzelne Verbindungen dieser Art sind beispielsweise in US-A 5,026,894, J. M. Tour et al., J. Am. Chem. Soc. 112 (1990) 5662 und J. M. Tour et al., Polym. Prepr. (1990) 408 als Verknüpfungselemente für polymere, organische Halbleiter beschrieben und wurden als Materialien für molekulare Elektronik vorgeschlagen. Eine mögliche Verwendung als EL-Materialien läßt sich daraus jedoch nicht ableiten.

Gegenstand der Erfindung ist daher die Verwendung von Heterospiroverbindungen der allgemeinen Formel (I), 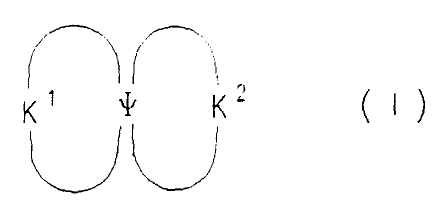 wobei
ψ ein Element der 4. Hauptgruppe des Periodensystems mit Ausnahme von Kohlenstoff bedeutet, vorzugsweise Sn, Ge oder Si, besonders bevorzugt Ge oder Si, und
K¹ und K² unabhängig voneinander konjugierte Systeme bedeuten, in Elektrolumineszenzvorrichtungen.

Verbindungen der Formel (I) zeichnen sich durch eine gute Löslichkeit in gängigen organischen Lösungsmitteln, verbesserte Filmbildungseigenschaften und eine deutlich verringerte Tendenz zur Kristallisation aus. Dadurch wird die Herstellung von Elektrolumineszenzvorrichtungen erleichtert und ihre Lebensdauer erhöht. Die Emissionseigenschaften der erfindungsgemäß eingesetzten Verbindungen können durch die Wahl geeigneter Substituenten über den ganzen Bereich des sichtbaren Spektrums eingestellt werden. Darüberhinaus erlaubt die kovalent gebundene Anordnung der zwei Teile der Spiroverbindung einen molekularen Aufbau in der Weise, daß bei beiden Hälften des Moleküls unabhängig bestimmte Eigenschaften eingestellt werden können. So kann die eine Hälfte z.B. Ladungstransport- oder Ladungsinjektionseigenschaften besitzen, während die andere lichtemittierende Eigenschaften besitzt. Die durch die kovalente Anknüpfung fixierte räumliche Nähe der beiden Hälften ist dabei günstig für die Energieübertragung (siehe z.B. B. Liphardt, W. Lüttke, Liebigs Ann. Chem. 1981, 1118).

Bevorzugte Verbindungen der Formel (I) sind Heterospiroverbindungen der Formel (II), 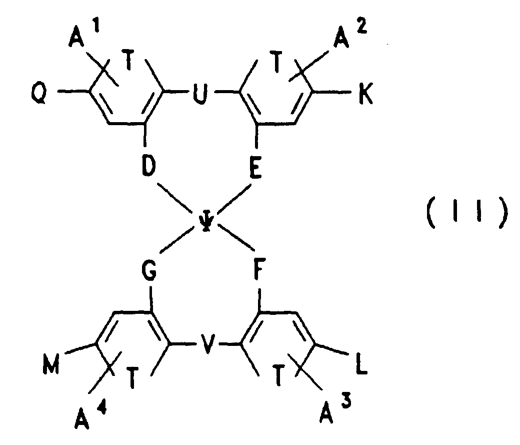 wobei die Symbole und Indizes folgende Bedeutungen haben:
- ψ: ist Si, Ge, Sn;
- D, E, F, G: sind gleich oder verschieden -CR¹R²-, -O-, -S-, -NR³- oder eine chemische Bindung;
- U, V: sind gleich oder verschieden -CR¹R²-, -O-, -S-, -NR³-, -SiR¹R²-, -SO₂-, -CO-, -CR⁴=CR⁵- oder eine chemische Bindung, mit der Maßgabe, daß entweder U oder V -CR⁴=CR⁵- oder eine chemische Bindung ist;
- T: ist -O-, -S-, -NR³-, -CR¹R²-, -CH=N-, -CA⁵=CA⁶-, -CH=CA⁷-, vorzugsweise -CH = CH- ;
- K, L, M, Q: sind gleich oder verschieden, cyclische oder acyclische Kohlenwasserstoffreste, die auch Heteroatome, wie Sauerstoff, Stickstoff und/oder Schwefel enthalten können und durch konjugierte Elektronensysteme gekennzeichnet sind;
- A¹, A², A³, A⁴: können gleich oder verschieden, die gleichen Bedeutungen wie K, L, M, Q haben oder sind Wasserstoff, Fluor oder ein Kohlenwasserstoffrest mit 1 bis 22, vorzugsweise 1 bis 15 C-Atomen, der auch Heteroatome, wie Sauerstoff, Stickstoff, Silicium oder Fluor enthalten kann; vorzugsweise eine lineare, verzweigte und/oder Cyclen enthaltende Alkyl-, Alkoxy- oder Alkyloxycarbonylgruppe, -CF₃, -CN, -NO₂, -NR⁶R⁷, -Ar oder -O-Ar;
- R¹, R², R³: sind gleich oder verschieden H oder ein Kohlenwasserstoffrest mit 1 bis 12 C-Atomen, wobei R¹ und R² zusammen auch einen gegebenenfalls substituierten Ring bilden können;
- R⁴, R⁵: haben, gleich oder verschieden, die gleichen Bedeutungen wie R¹, R², R³ oder sind Fluor oder -CF₃;
- R⁶, R⁷: sind gleich oder verschieden H oder ein Kohlenwasserstoffrest mit 1 bis 22 C-Atomen, der aliphatisch oder aromatisch, linear oder verzweigt sein kann und auch alicyclische Elemente enthalten kann, vorzugsweise Methyl, Ethyl, t-Butyl, cyclo-Hexyl, 3-Methylphenyl; oder R⁶ und R⁷ bilden zusammen einen Cyclus, vorzugsweise 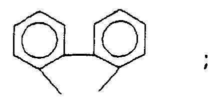
- Ar: ist ein aromatischer Rest mit bis zu 22 C-Atomen, vorzugsweise Phenyl, Biphenyl, 1-Naphthyl, 2-Naphthyl, 2-Thienyl, 2-Furanyl, wobei jeder dieser aromatischen Reste mit einem oder zwei Gruppen R⁴, R⁵ substituiert sein kann;
Q und A¹, K und A², L und A⁴, M und A³ können unabhängig voneinander auch jeweils zu einem Ring zusammengeschlossen sein, der gesättigt, partiell ungesättigt oder maximal ungesättigt sein kann, wobei bevorzugt ein anelliert aromatisches Ringsystem vorliegt.

Besonders bevorzugt sind Heterospirobifluorenderivate der Formel (III), 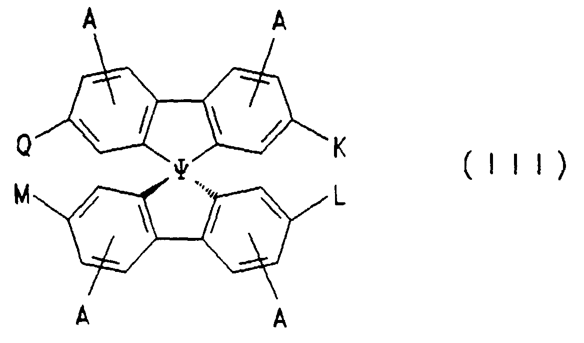 wobei die Symbole und Indizes folgende Bedeutungen haben:
- ψ: ist Si oder Ge;
- K, L, M, Q, A: sind gleich oder verschieden 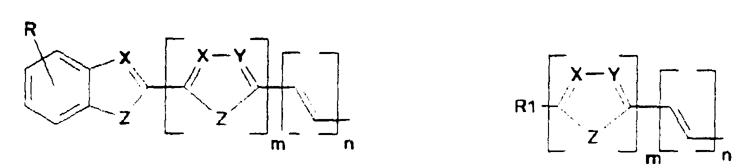 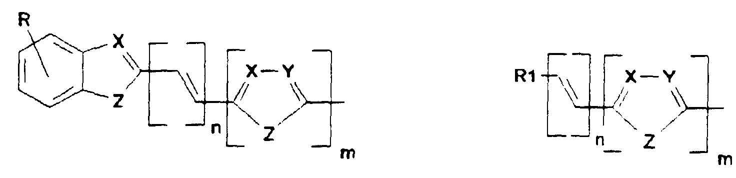 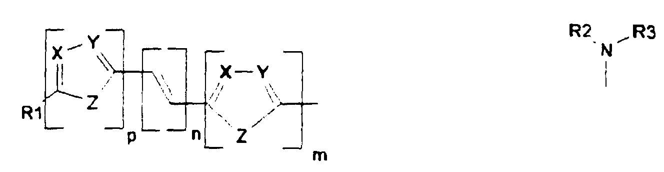
und
- A: kann auch, gleich oder verschieden die gleichen Bedeutungen wie R haben;
- R: kann, gleich oder verschieden, die gleichen Bedeutungen wie K, L, M, Q haben oder ist -H, eine lineare oder verzweigte Alkyl, Alkoxy oder Estergruppe mit 1 bis 22, vorzugsweise 1 bis 15, besonders bevorzugt 1 bis 12 C-Atomen, -CN, -NO₂, -NR²R³, -Ar oder -O-Ar;
- Ar: ist Phenyl, Biphenyl, 1-Naphthyl, 2-Naphthyl, 2-Thienyl, 2-Furanyl, wobei jede dieser Gruppen einen oder zwei Reste R tragen kann,
- m, n, p: sind unabhängig voneinander, gleich oder verschieden 0, 1, 2 oder 3;
- X, Y: sind gleich oder verschieden CR, N;
- Z: ist -O-, -S-, -NR¹-, -CR¹R⁴-, -CH=CH-, -CH=N-;
- R¹, R⁴: können, gleich oder verschieden, die gleichen Bedeutungen wie R haben;
- R², R³: sind gleich oder verschieden H, eine lineare oder verzweigte Alkylgruppe mit 1 bis 22 C-Atomen, -Ar, 3-Methylphenyl.

Bevorzugte Verbindungen der Formel (III) sind solche der Formel (IIIa)-(IIIg)
IIIa) K = L = M = Q und ist aus der Gruppe: 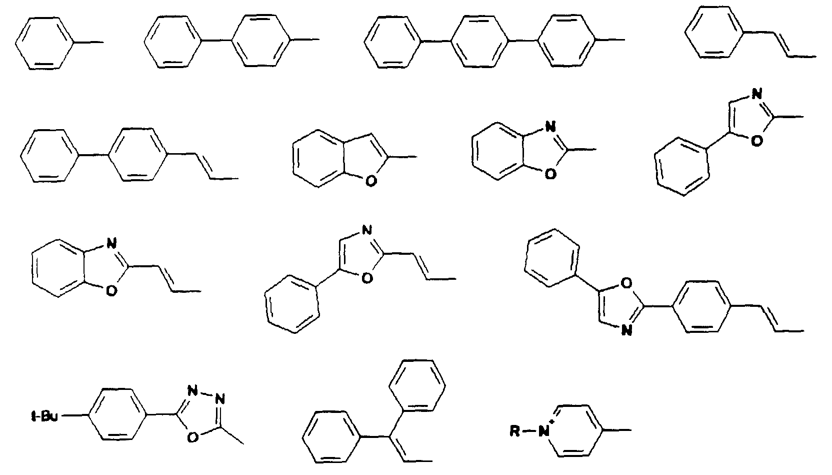 R = C₁-C₂₂-Alkyl, (CH₂)ₓ-SO₃⁻ mit x = 2, 3 oder 4
Illb) K = M = H und Q = L und ist aus der Gruppe: 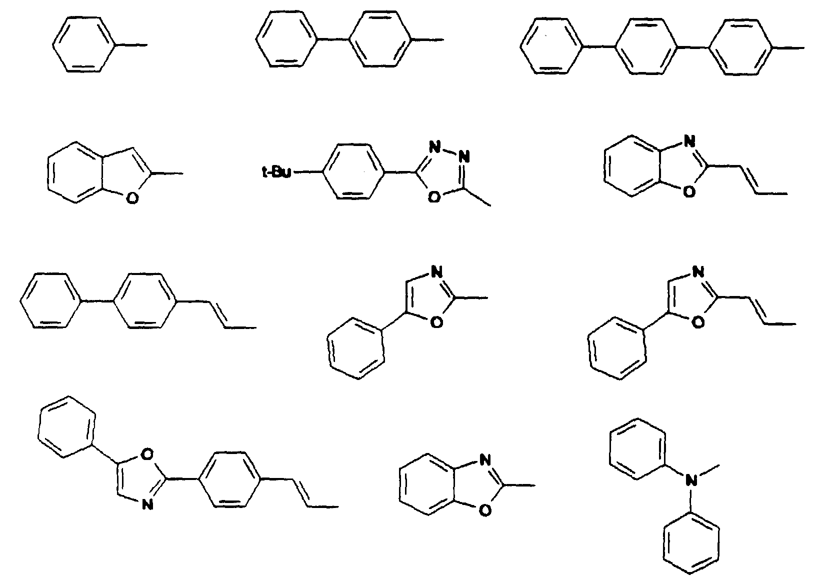
IIIc) K = M und ist aus der Gruppe: 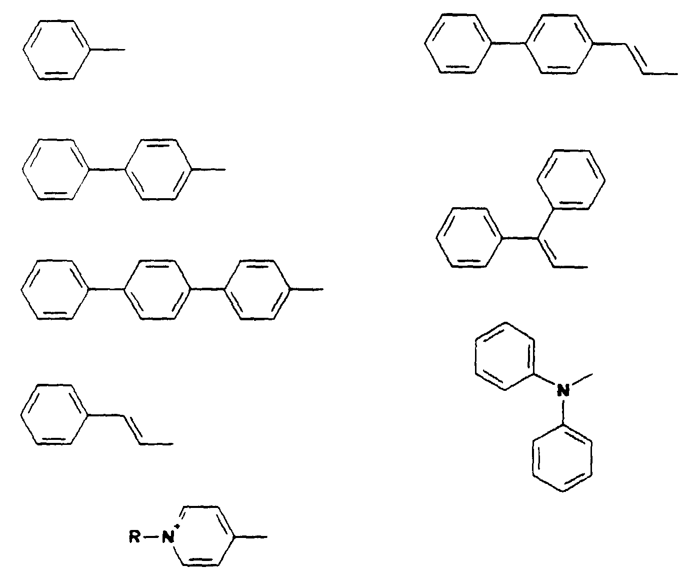 R = C₁-C₂₂-Alkyl, (CH₂)ₓ-SO₃⁻ mit x = 2, 3 oder 4
   und Q = L und ist aus der Gruppe: 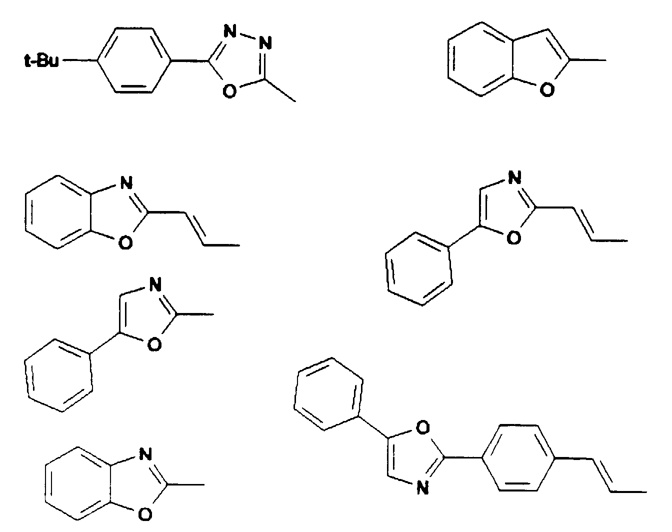
IIId) K = M und ist aus der Gruppe: 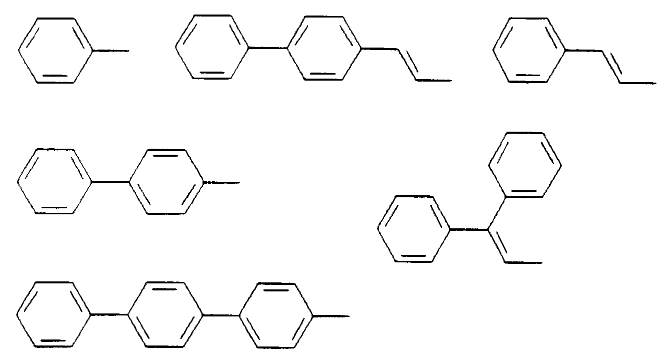 und Q = L und ist aus der Gruppe: 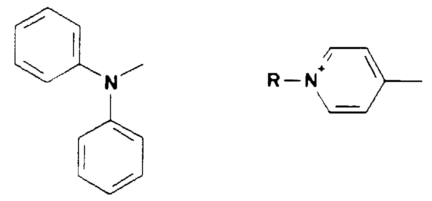 R = C₁-C₂₂-Alkyl, (CH₂)ₓ-SO₃ ⁻ mit x = 2, 3 oder 4
IIIe) K = L = H und M = Q und ist aus der Gruppe: 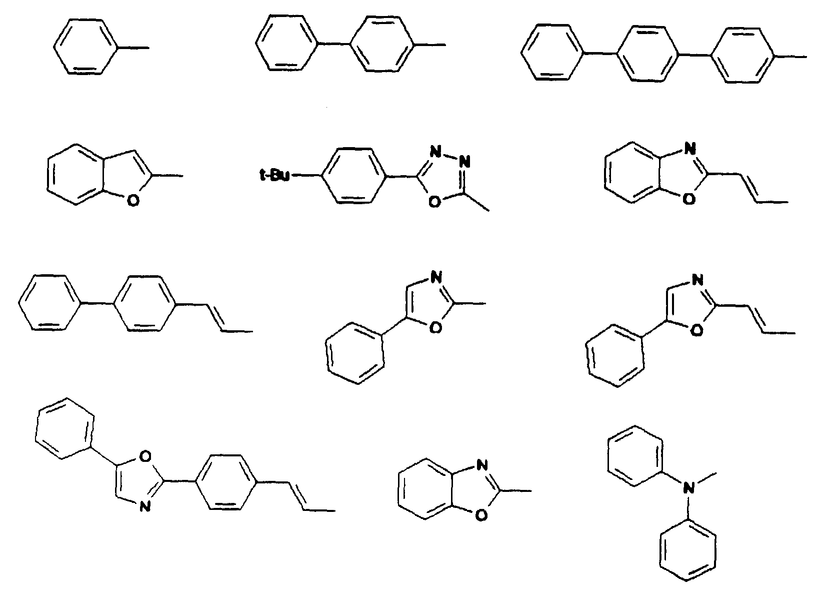
IIIf) K = M und ist aus der Gruppe: 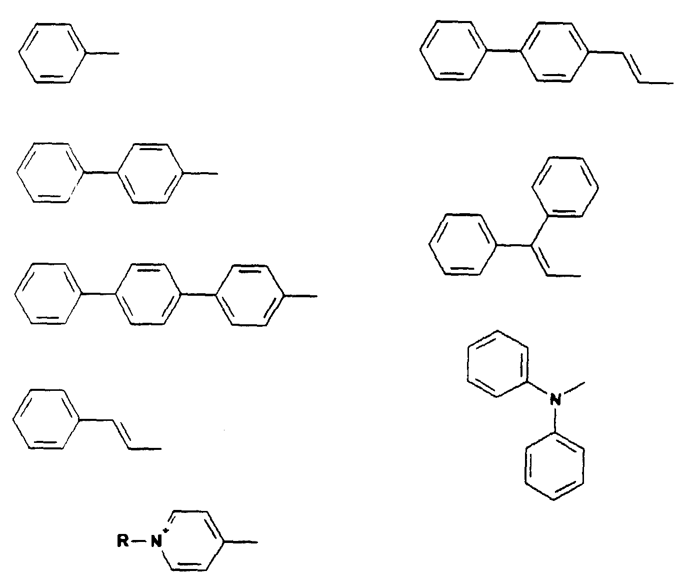 R = C₁-C₂₂-Alkyl, (CH₂)ₓ-SO₃ ⁻ mit x = 2, 3 oder 4
   und M = Q und ist aus der Gruppe: 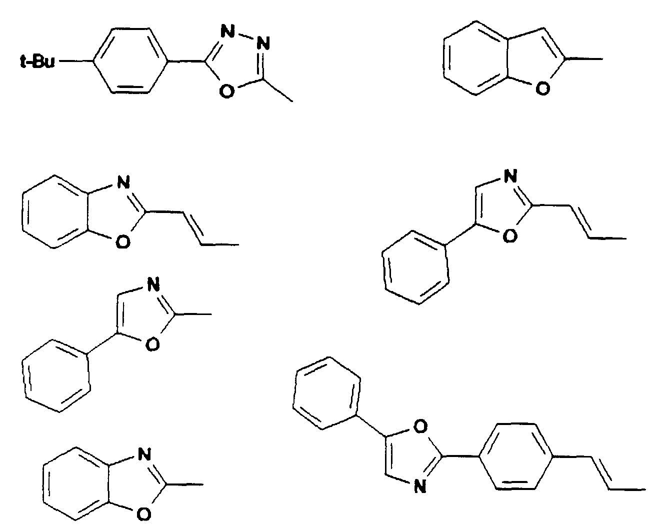
IIIg) K = L und ist aus der Gruppe: 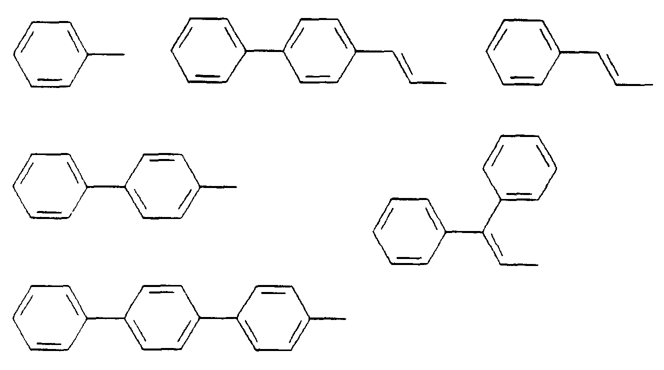 und M = Q und ist aus der Gruppe: 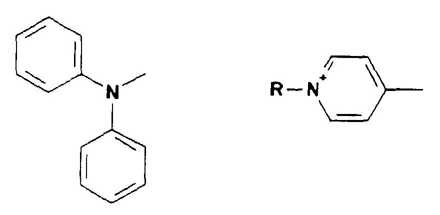 R = C₁-C₂₂-Alkyl, (CH₂)ₓ-SO₃ ⁻ mit x = 2, 3 oder 4

Besonders bevorzugte Verbindungen der Formel (III) sind solche der Formeln (IIIaa) bis (IIIbd):
(IIIaa) K = L = M = Q und ist aus der Gruppe: 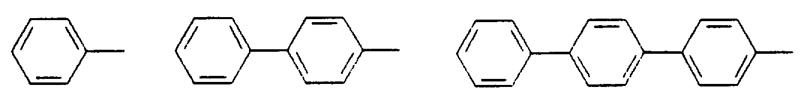
(IIIab) K = M = H und Q = L und ist aus der Gruppe: 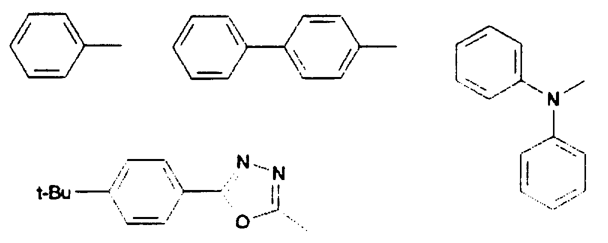
(IIIac) K = M und ist aus der Gruppe: 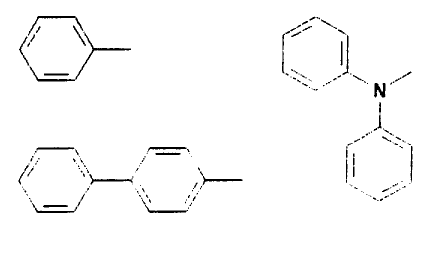 und Q = L und ist: 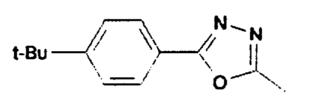
(IIIad) K = M und ist aus der Gruppe: 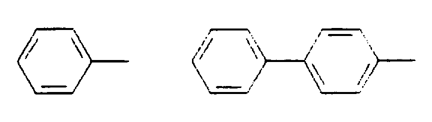
(IIIba) K = L = M = Q und ist aus der Gruppe: 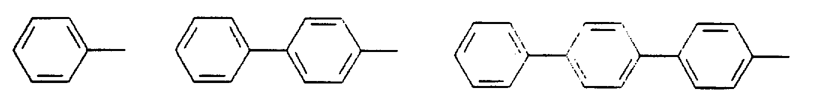
(IIIbb) K = L = H und M = Q und ist aus der Gruppe: 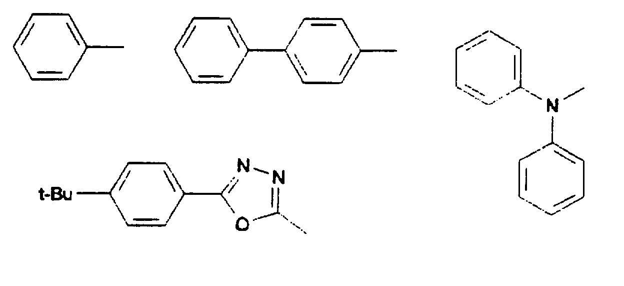
(IIIbc) K = L und ist aus der Gruppe: 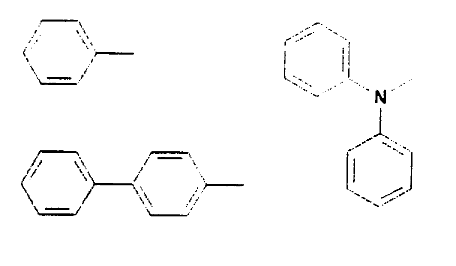 und M = Q und ist: 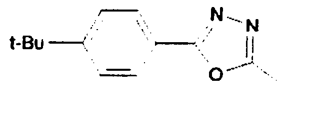
(IIIbd) K = L und ist aus der Gruppe: 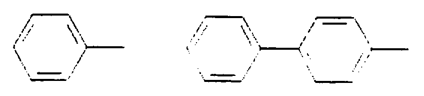 und M = Q und ist aus der Gruppe: 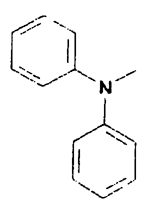 und Q = L und ist aus der Gruppe:

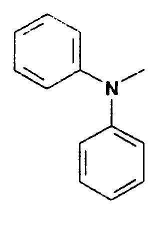

Ganz besonders bevorzugte Heterospiroverbindungen der Formel (III) sind Spirobi-9-sila-fluorene, wie 2,2',4,4',7,7'-Hexakis(biphenylyl)-9,9'-spirobi-9-sila-fluoren, 2,2',4,4',7,7'-Hexakis(terphenylyl)-9,9'-spirobi-9-sila-fluoren, sowie die in der Tabelle 1 aufgeführten Verbindungen, bei denen die Abkürzungen G1 bis G14 für die folgenden Strukturelemente stehen:

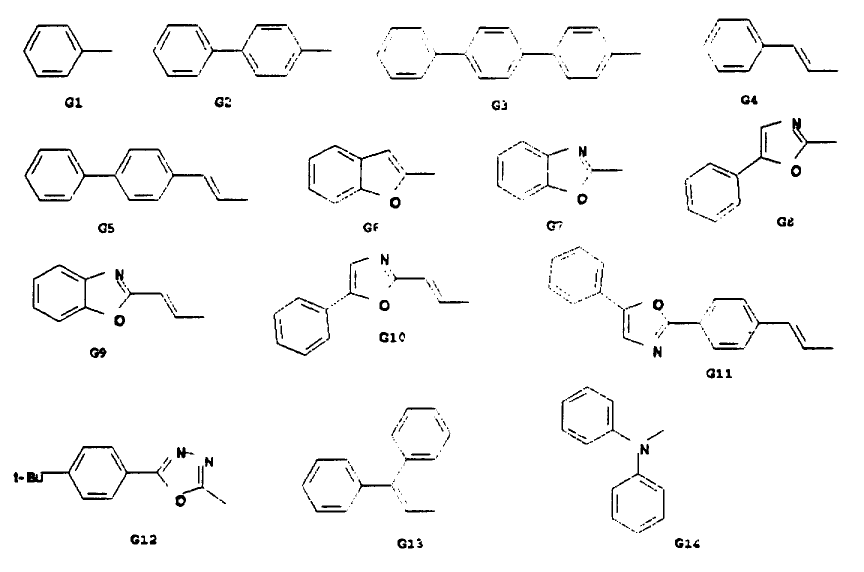

**Tabelle 1:**

| Spirobi-9-sila-fluorenderivate | | | | |
|---|---|---|---|---|
| Verbindung | K | L | M | Q |
| Spiro-1 | G1 | G1 | G3 | G3 |
| Spiro-2 | G1 | G1 | G4 | G4 |
| Spiro-3 | G1 | G1 | G5 | G5 |
| Spiro-4 | G1 | G1 | G6 | G6 |
| Spiro-5 | G1 | G1 | G7 | G7 |
| Spiro-6 | G1 | G1 | G8 | G8 |
| Spiro-7 | G1 | G1 | G9 | G9 |
| Spiro-8 | G1 | G1 | G10 | G10 |
| Spiro-9 | G1 | G1 | G11 | G11 |
| Spiro-10 | G1 | G1 | G12 | G12 |
| Spiro-11 | G1 | G1 | G13 | G13 |
| Spiro-12 | G1 | G1 | G14 | G14 |
| Spiro-13 | G2 | G2 | G2 | G2 |
| Spiro-14 | G2 | G2 | G3 | G3 |
| Spiro-15 | G2 | G2 | G4 | G4 |
| Spiro-16 | G2 | G2 | G5 | G5 |
| Spiro-17 | G2 | G2 | G6 | G6 |
| Spiro-18 | G2 | G2 | G7 | G7 |
| Spiro-19 | G2 | G2 | G8 | G8 |
| Spiro-20 | G2 | G2 | G9 | G9 |
| Spiro-21 | G2 | G2 | G10 | G10 |
| Spiro-22 | G2 | G2 | G11 | G11 |
| Spiro-23 | G2 | G2 | G12 | G12 |
| Spiro-24 | G2 | G2 | G13 | G13 |
| Spiro-25 | G2 | G2 | G14 | G14 |
| Spiro-26 | G3 | G3 | G3 | G3 |
| Spiro-27 | G3 | G3 | G4 | G4 |
| Spiro-28 | G3 | G3 | G5 | G5 |
| Spiro-29 | G3 | G3 | G6 | G6 |
| Spiro-30 | G3 | G3 | G7 | G7 |
| Spiro-31 | G3 | G3 | G8 | G8 |
| Spiro-32 | G3 | G3 | G9 | G9 |
| Spiro-33 | G3 | G3 | G10 | G10 |
| Spiro-34 | G3 | G3 | G11 | G11 |
| Spiro-35 | G3 | G3 | G12 | G12 |
| Spiro-36 | G3 | G3 | G13 | G13 |
| Spiro-37 | G3 | G3 | G14 | G14 |
| Spiro-38 | G4 | G4 | G4 | G4 |
| Spiro-39 | G5 | G5 | G5 | G5 |
| Spiro-40 | G6 | G6 | G6 | G6 |
| Spiro-41 | G7 | G7 | G7 | G7 |
| Spiro-42 | G8 | G8 | G8 | G8 |
| Spiro-43 | G9 | G9 | G9 | G9 |
| Spiro-44 | G10 | G10 | G10 | G10 |
| Spiro-45 | G11 | G11 | G11 | G11 |
| Spiro-46 | G12 | G12 | G12 | G12 |
| Spiro-47 | G13 | G13 | G13 | G13 |
| Spiro-48 | G14 | G14 | G14 | G14 |
| Spiro-49 | H | H | G3 | G3 |
| Spiro-50 | H | H | G4 | G4 |
| Spiro-51 | H | H | G5 | G5 |
| Spiro-52 | H | H | G6 | G6 |
| Spiro-53 | H | H | G7 | G7 |
| Spiro-54 | H | H | G8 | G8 |
| Spiro-55 | H | H | G9 | G9 |
| Spiro-56 | H | H | G10 | G10 |
| Spiro-57 | H | H | G11 | G11 |
| Spiro-58 | H | H | G12 | G12 |
| Spiro-59 | H | H | G13 | G13 |
| Spiro-60 | H | H | G14 | G14 |
| Spiro-61 | G1 | G3 | G3 | G1 |
| Spiro-62 | G1 | G4 | G4 | G1 |
| Spiro-63 | G1 | G5 | G5 | G1 |
| Spiro-64 | G1 | G6 | G6 | G1 |
| Spiro-65 | G1 | G7 | G7 | G1 |
| Spiro-66 | G1 | G8 | G8 | G1 |
| Spiro-67 | G1 | G9 | G9 | G1 |
| Spiro-68 | G1 | G10 | G10 | G1 |
| Spiro-99 | G1 | G11 | G11 | G1 |
| Spiro-70 | G1 | G12 | G12 | G1 |
| Spiro-71 | G1 | G13 | G13 | G1 |
| Spiro-72 | G1 | G14 | G14 | G1 |
| Spiro-73 | G2 | G4 | G4 | G2 |
| Spiro-74 | G2 | G5 | G5 | G2 |
| Spiro-75 | G2 | G6 | G6 | G2 |
| Spiro-76 | G2 | G7 | G7 | G2 |
| Spiro-77 | G2 | G8 | G8 | G2 |
| Spiro-78 | G2 | G9 | G9 | G2 |
| Spiro-79 | G2 | G10 | G10 | G2 |
| Spiro-80 | G2 | G11 | G11 | G2 |
| Spiro-81 | G2 | G12 | G12 | G2 |
| Spiro-82 | G2 | G13 | G13 | G2 |
| Spiro-83 | G2 | G14 | G14 | G2 |
| Spiro-84 | G3 | G4 | G4 | G3 |
| Spiro-85 | G3 | G5 | G5 | G3 |
| Spiro-86 | G3 | G6 | G6 | G3 |
| Spiro-87 | G3 | G7 | G7 | G3 |
| Spiro-88 | G3 | G8 | G8 | G3 |
| Spiro-89 | G3 | G9 | G9 | G3 |
| Spiro-90 | G3 | G10 | G10 | G3 |
| Spiro-91 | G3 | G11 | G11 | G3 |
| Spiro-92 | G3 | G12 | G12 | G3 |
| Spiro-93 | G3 | G13 | G13 | G3 |
| Spiro-94 | G3 | G14 | G14 | G3 |
| Spiro-95 | H | G3 | G3 | H |
| Spiro-96 | H | G4 | G4 | H |
| Spiro-97 | H | G5 | G5 | H |
| Spiro-98 | H | G6 | G6 | H |
| Spiro-99 | H | G7 | G7 | H |
| Spiro-100 | H | G8 | G8 | H |
| Spiro-101 | H | G9 | G9 | H |
| Spiro-102 | H | G10 | G10 | H |
| Spiro-103 | H | G11 | G11 | H |
| Spiro-104 | H | G12 | G12 | H |
| Spiro-105 | H | G13 | G13 | H |
| Spiro-106 | H | G14 | G14 | H |

Die erfindungsgemäß verwendeten Heterospiroverbindungen sind teilweise bekannt und teilweise neu.

Gegenstand der Erfindung sind daher auch Spiroverbindungen der Formel (IV), 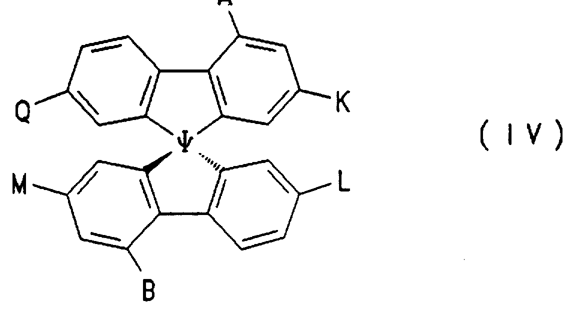 wobei die Symbole folgende Bedeutungen haben:
- ψ: ist Si, Ge oder Sn;
- A, B, K, L, M, Q: sind gleich oder verschieden 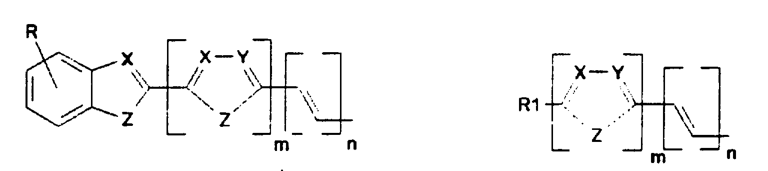 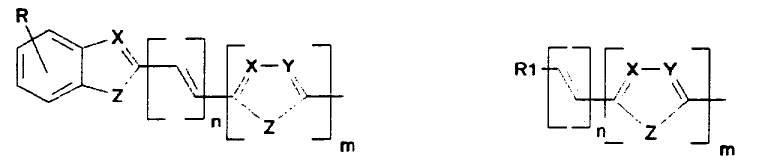 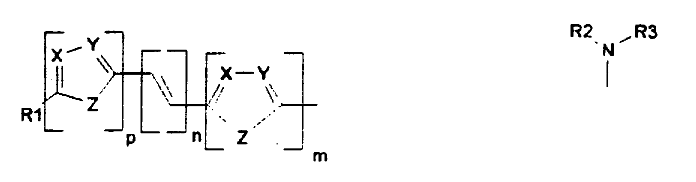
und
- A, B: können auch gleich oder verschieden eine lineare oder verzweigte Alkyl-, Alkyloxy- oder Estergruppe mit 1 bis 22 C-Atomen, -CN, -NO₂, -Ar oder -O-Ar sein;
- R: ist -H, eine lineare oder verzweigte Alkyl, Alkoxy oder Estergruppe mit 1 bis 22, vorzugsweise 1 bis 15, besonders bevorzugt 1 bis 12 C-Atomen, -CN, -NO₂, -NR²R³, -Ar oder -O-Ar;
- Ar: ist Phenyl, Biphenyl, 1-Naphthyl, 2-Naphthyl, 2-Thienyl, 2-Furanyl, wobei jede dieser Gruppen einen oder zwei Reste R tragen kann;
- m, n, p: sind unabhängig voneinander, gleich oder verschieden 0, 1, 2 oder 3;
- X, Y: sind gleich oder verschieden CR, Stickstoff;
- Z: ist -O-, -S-, -NR¹-, -CR¹R⁴-, -CH=CH-, -CH=N-;
- R¹, R⁴: können, gleich oder verschieden, die gleichen Bedeutungen wie R haben;
- R², R³: sind gleich oder verschieden H, eine lineare oder verzweigte Alkylgruppe mit 1 bis 22 C-Atomen, -Ar oder 3-Methylphenyl.

Die Herstellung der erfindungsgemäßen oder erfindungsgemäß verwendeten Spiroverbindungen erfolgt nach an sich literaturbekannten Methoden, wie sie in Standardwerken zur Organischen Synthese, z.B. Houben-Weyl, Methoden der Organischen Chemie, Georg-Thieme-Verlag, Stuttgart, insbesondere Band 13/5, S. 30-87 und in den entsprechenden Bänden der Serie "The Chemistry of Heterocyclic Compounds" von A. Weissberger und E. C. Taylor (Herausgeber) beschrieben werden.

Die Herstellung erfolgt dabei unter Reaktionsbedingungen, die für die genannten Umsetzungen bekannt und geeignet sind. Dabei kann auch von an sich bekannten, hier nicht näher erwähnten Varianten Gebrauch gemacht werden. Verbindungen der Formel (III) werden beispielsweise ausgehend vom Bis-[biphenyl-2,2'-diyl]silan (= 9,9'-Spirobi(9H-)-silafluoren)) (V) erhalten, dessen Synthese z.B. von H. Gilman, R.D. Gorsich, J.Am.Chem.Soc. 1958, 80, 3243, beschrieben ist.

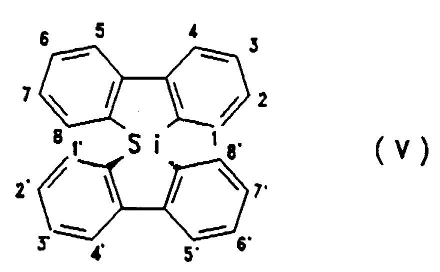

Die Herstellung von Verbindungen der Formel (IIIa) kann beispielsweise ausgehend von einer Tetrahalogenierung in den Positionen 2,2',7,7' des 9,9'-Spirobi-9-silafluorens und anschließender Substitutionsreaktion erfolgen,die von analogen C-Spiroverbindungen bekannt sind (siehe z.B. US-A-5,026,894). Dies kann beispielsweise über die entsprechenden Cyanoverbindungen zu Aldehyd- oder Carbonsäurefunktionalität führen, welche, z. B. zum Aufbau von Heterocyclen verwendet werden.

Die Herstellung von Verbindungen der Formel (Illb) kann beispielsweise analog zu denen der Formel (IIIa) erfolgen, wobei die stöchiometrischen Verhältnisse bei der Umsetzung so gewählt werden, daß die Positionen 2,2' bzw. 7,7' funktionalisiert werden (siehe z.B. J. H. Weisburger, E. K. Weisburger, F. E. Ray, J. Am. Chem. Soc. 1959, 72, 4253; F. K. Sutcliffe, H. M. Shahidi, D. Paterson, J. Soc. Dyers Colour 1978, 94, 306 und G. Haas, V. Prelog, Helv. Chim. Acta 1969, 52, 1202).

Die Herstellung von Verbindungen der Formel (IIIc) und (IIId) kann beispielsweise über eine Dibromierung in 7,7'-Stellung des analog zu (IIIa) synthetisierten 2,2'-Dicyano- in 9,9'-Spirobi-9-silafluorens und anschließende Umsetzungen analog zu denen bei Verbindungen (IIIa) erfolgen.

Verbindungen der Formel (IIIe)-(IIIg) sind beispielsweise herstellbar durch Wahl geeignet substituierter Ausgangsverbindungen beim Aufbau des Spirosilabifluorens z.B.: 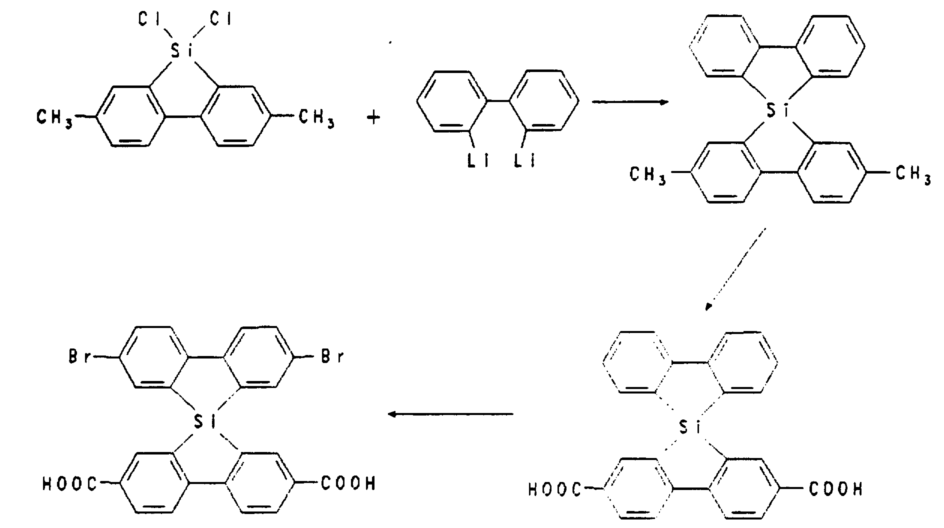 und, z.B.:

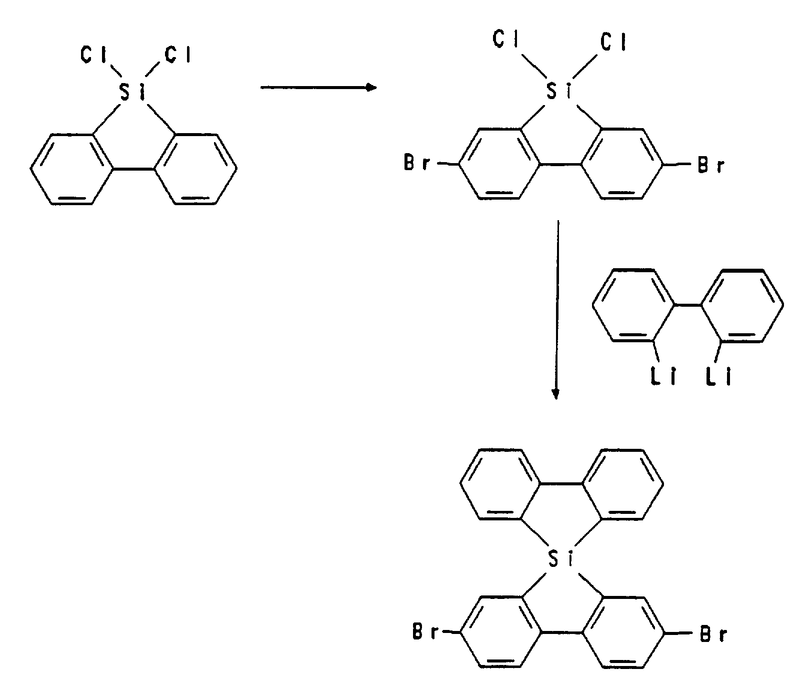

Darüberhinaus sind die dem Fachmann geläufigen Synthesesequenzen wie Nitrierung, Reduzierung, Diazotierung und Sandmeyer-Reaktion einzusetzen.
Für die Synthese der Gruppen K, L, M, Q sei beispielsweise verwiesen auf DE-A 23 44 732, 24 50 088, 24 29 093, 25 02 904, 26 36 684, 27 01 591 und 27 52 975 für Verbindungen mit 1,4-Phenylen-Gruppen;
DE-A 26 41 724 für Verbindungen mit Pyrimidin-2,5-diyl-Gruppen;
DE-A 40 26 223 und EP-A 0 391 203 für Verbindungen mit Pyridin-2,5-diyl-Gruppen;
DE-A 32 31 462 für Verbindungen mit Pyridazin-3,6-diyl-Gruppen; N. Miyaura, T. Yanagi und A. Suzuki in Synthetic Communications 11 (1981) 513 bis 519, DE-A-39 30 663, M. J. Sharp, W. Cheng, V. Snieckus in Tetrahedron Letters 1987, 28, 5093; G. W. Gray in J. Chem. Soc. Perkin Trans II, 1989, 2041 und Mol. Cryst. Liq. Cryst. 1989, 172, 165, Mol. Cryst. Liq. Cryst. 1991, 204, 43 und 91; EP-A 0 449 015; WO 89/12039; WO 89/03821; EP-A 0 354 434 für die direkte Verknüpfung von Aromaten und Heteroaromaten;

Die Herstellung disubstituierter Pyridine, disubstituierter Pyrazine, disubstituierter Pyrimidine und disubstituierter Pyridazine findet sich beispielsweise in den entsprechenden Bänden der Serie "The Chemistry of Heterocyclic Compounds" von A. Weissberger und E. C. Taylor (Herausgeber).

Erfindungsgemäß finden die beschriebenen Spiroverbindungen der Formeln (I), (II) und (III) als Elektrolumineszenzmaterialien Verwendung, d.h., sie dienen als aktive Schicht in einer Elektrolumineszenzvorrichtung. Gegenstand der Erfindung ist daher auch ein Elektrolumineszenzmaterial, enthaltend eine oder mehrere Verbindungen der Formeln (I), (II) und/oder (III). Als aktive Schicht im Sinne der Erfindung gelten Elektrolumineszenzmaterialien, die befähigt sind, bei Anlegen eines elektrischen Feldes, Licht abzustrahlen (lichtemittierende Schicht), sowie Materialien, welche die Injektion und/oder den Transport der positiven und/oder negativen Ladungen verbessern (Ladungsinjektionsschichten und Ladungstransportschichten).

Gegenstand der Erfindung ist daher auch eine Elektrolumineszenzvorrichtung mit einer oder mehreren aktiven Schichten, die eine oder mehrere Verbindungen der Formel (I), (II) und/oder (III) enthalten. Die aktive Schicht kann beispielsweise eine lichtemittierende Schicht und/oder eine Transportschicht und/oder eine Ladungsinjektionsschicht sein. Hervorzuheben sind die hervorragenden Lochleitereigenschaften der erfindungsgemäßen Materialien, die als Lochtransportschicht z.B. Anwendung in Fotokopierern und Laserdruckern finden kann.
Der allgemeine Aufbau solcher Elektrolumineszenzvorrichtungen ist beispielsweise in US-A-4,539,507 und US-A-5,151,629 beschrieben.

Sie enthalten üblicherweise eine elektrolumineszierende Schicht zwischen einer Kathode und einer Anode, wobei mindestens eine der Elektroden transparent ist. Zusätzlich kann zwischen der elektrolumineszierenden Schicht und der Kathode eine Elektroneninjektions- und/oder Elektronentransportschicht eingebracht sein und/oder zwischen der elektrolumineszierenden Schicht und der Anode eine Lochinjektions- und/oder Lochtransportschicht eingebracht sein. Als Kathode kann z.B. Ca, Mg, Al, In, Mg/Ag dienen. Als Anode können z.B. Au oder ITO (Indiumoxid/Zinnoxid auf einem transparentem Substrat, z.B. aus Glas oder einem transparenten Polymer) dienen.

Im Betrieb wird die Kathode auf negatives Potential gegenüber der Anode gesetzt. Dabei werden Elektronen von der Kathode in die Elektroneninjektionsschicht /Elektronentransportschicht bzw. direkt in die lichtemittierende Schicht injiziert. Gleichzeitig werden Löcher von der Anode in die Lochinjektionsschicht/ Lochtransportschicht bzw. direkt in die lichtemittierende Schicht injiziert.

Die injizierten Ladungsträger bewegen sich unter dem Einfluß der angelegten Spannung durch die aktiven Schichten aufeinander zu. Dies führt an der Grenzfläche zwischen Ladungstransportschicht und lichtemittierender Schicht bzw. innerhalb der lichtemittierenden Schicht zu Elektronen/Loch-Paaren, die unter Aussendung von Licht rekombinieren.

Die Farbe des emittierten Lichtes kann durch die als lichtemittierende Schicht verwendete Verbindung variiert werden, wobei ausdrücklich auch Gemische der erfindungsgemäßen Stoffe untereinander wie auch mit anderen, z.B. entsprechenden Carbospiro-Verbindungen verwiesen wird.

Elektrolumineszenzvorrichtungen finden Anwendung z.B. als selbstleuchtende Anzeigeelemente, wie Kontrollampen, alphanumerische Displays, Hinweisschilder, und in optoelektronischen Kopplern.

Die Erfindung wird durch die Beispiele näher erläutert, ohne sie darauf beschränken zu wollen.

### Beispiele

### Beispiel 1:

### 2,2'-Dilithiobiphenyl

Zu einer eisgekühlten, kräftig gerührten Lösung von 4,0 g (12,9 mmol) 2,2'-Dibrombiphenyl in 40 ml absolutem Diethylether (Ether) wurde innerhalb von 5 Minuten 26 ml einer Lösung von 28 mmol n-BuLi in Ether zugetropft und anschließend 5 Stunden bei Raumtemperatur nachgerührt.

### Beispiel 2:

### Bis-(biphenyl-2,2'-diyl)-silan (9,9'-Spirobi-9-sila-fluoren)

Eine gemäß Beispiel 1 hergestellte Lösung von 24 mmol 2,2'-Dilithiobiphenyl in 70 ml Ether wurde innerhalb einer Stunde zu einer kräftig gerührten Lösung von 1,87 g (11 mmol) Siliciumtetrachlorid in 30 ml Ether zugetropft. Die Mischung wurde weitere 1,5 Stunden bei Raumtemperatur gerührt und 3 Stunden am Rückfluß gekocht. Anschließend wurden 50 ml Benzol zugesetzt und die Mischung zwei weitere Stunden am Rückfluß gekocht. Nach Ausschütteln mit 100 ml Wasser wird die organische Phase über Magnesiumsulfat getrocknet und filtriert, der größte Teil des Ethers am Rotavapor abdestilliert. Aus der abgekühlten Lösung wurden 1,45 g Rohprodukt mit Fp. = 222 bis 225°C isoliert. Das Filtrat ergab nach dem Einengen weitere 0,6 g (Gesamtausbeute 56 %). Kristallisation aus Ethanol ergab einen Schmelzpunkt von 227°C.

| Elementaranalyse | % | C | H | Si |
|---|---|---|---|---|
| | Ber. | 86,72 | 4,85 | 8,44 |
| | Gef. | 86,86 | 4,98 | 8,33 |

Die bemerkenswert hohe Stabilität dieser Verbindung zeigt sich am Siedepunkt von 460°C, der ohne sichtbare Zersetzung erreicht wird.

### Beispiel 3:

### Bis-(biphenyl-2,2'-diyl)-german (9,9'-Spirobi-9-germa-fluoren)

Eine Lösung von 50 mmol 2,2'-Di!ithiobiphenyl hergestellt in 140 ml Ether, gemäß Beispiel 1, wurde gemäß Beispiel 2 mit 5,35 g (25 mmol) Germaniumtetrachlorid umgesetzt. Nach Aufarbeitung und Umkristallisation aus Ethylacetat wurden 2,77 g (29 %) Produkt erhalten. Weiße Prismen, Schmelzpunkt 245°C, Siedepunkt 470°C ohne Zersetzung.

| Elementaranalyse | % | Ge |
|---|---|---|
| | Ber. | 19,23 |
| | Gef. | 18,88 |

### Beispiel 4:

### Biphenyl-2,2'-diyl-siliciumdichlorid

78 mmol 2,2'-Dilithiobiphenyl hergestellt in 230 ml Ether, gemäß Beispiel 1, wurden gemäß Beispiel 2 mit 252 g (1,48 mol, d.h. 18-facher Überschuß) Siliciumtetrachlorid umgesetzt. Nach Abdestillieren des überschüssigen SiCl₄ und Aufarbeitung wurden 3,5 g eines festen Produkts erhalten, das nach Umkristallisieren aus Ethylacetat 2,89 g (22 %) Bis-(biphenyl-2,2'-diyl)silan, gemäß Beispiel 2, ergab. Die gesammelten Mutterlaugen wurden eingeengt und das zurückbleibende Öl bei 0,01 mbar destilliert, wobei als Vorlauf eine kleine Menge Biphenyl und als Hauptfraktion bei 108 bis 110°C 7,41 g (38 %) Biphenyl-2,2'-diyl-siliciumdichlorid übergingen.

| Elementaranalyse | % | Cl | Si |
|---|---|---|---|
| | Ber. | 28,3 | 11,33 |
| | Gef. | 26,5 | 10,75 |

### Beispiel 5:

### 10,10-Biphenyl-2,2'-diyl-phenoxasilin

Eine Lösung von 120 mmol 2,2'-Dilithio-diphenylether in 180 ml THF, hergestellt gemäß H. Gilman, W. J. Trepka, J. Org. Chem 27, 1418 (1962), wurde zu einer Lösung von 37,7 g (150 mmol)
Biphenyl-2,2'-diyl-siliciumdichlorid in 200 ml THF gegeben, das gemäß Beispiel 4 hergestellt wurde. Man rührte 12 Stunden bei 20°C, hydrolysierte mit einer Mischung aus Eis und Schwefelsäure und extrahierte die wäßrige Phase mit Ether. Nach destillativer Aufarbeitung bei ≤ 0,05 mm wurde die bei 150°C übergehende Hauptfraktion aus Ethanol umkristallisiert: 12,5 g (30 %).

### Beispiel 6:

### Bis-(bibenzyl-2,2'-diyl)-silan

Eine Lösung von 2,1 ml (20 mmol) Siliciumtetrachlorid in 50 ml THF wurde zu einer Lösung von 2,2'-Dilithiobibenzyl zugetropft, die zuvor aus 15 g (40 mmol) 2,2'-Dibrombibenzyl und 97 mmol einer 1,7 molaren n-Butyllithium in Hexanfraktion bereitet worden war. Es wurde 1 Stunde zum Rückfluß erhitzt und wie in Beispiel 5 aufgearbeitet. Bei einem Druck von 0,05 mm gingen zwischen 125 und 210°C 5,0 g eines erstarrenden Öls über, das nach zweimaliger Kristallisation 1,0 g (13 %) Bis-(bibenzyl-2,2'-diyl)-silan mit Fp. 175°C ergab.

| Elementaranalyse | % | C | H |
|---|---|---|---|
| | Ber. | 86,60 | 6,19 |
| | Gef. | 86,21 | 6,05 |

### Beispiel 7:

### Bis-(stilben-2,2'-diyl)-silan aus

### Bis-(α, α'(β')-dibrombibenzyl-2,2'-diyl)-silan

Eine Aufschlämmung von 1,94 g (5 mmol) Bis(bibenzyl-2,2'-diyl)-silan, hergestellt gemäß Beispiel 6, und 1,78 g (10 mmol) N-Bromsuccinimid in 100 ml Tetrachlormethan wurden unter Bestrahlung mit einer 300 W-Wolframglühfadenlampe zum Sieden erhitzt. Das gebildete Succinimid wurde abgesaugt, das Filtrat am Rotavapor zur Trockne eingeengt, der Rückstand in 15 ml Toluol aufgenommen und mit 2 ml 2-Dimethylaminoethanol versetzt. Die Mischung wurde 48 Stunden gerührt und dann 6 Stunden zum Sieden erhitzt. Das Toluol wurde im Vakuum entfernt, der Rückstand mit 50 ml 5 gew.-%iger Natronlauge versetzt und mit Ether ausgeschüttelt. Nach Trocknung über Magnesiumsulfat wurde der Ether verdampft und der Rückstand in Toluol/Cyclohexan an 30 g Kieselgel chromatographisch gereinigt.

### Beispiel 8:

### 3,3',5,5'-Tetraphenyl-9-9'-spiro-9H-bi-9-silafluoren aus Tetrakis-(biphenylyl-4)-silan

10,8 g (46,3 mmol) 4-Brombiphenyl wurden mit 1,95 g (11,6 mmol) Siliciumtetrachlorid in 100 ml absolutem Ether gelöst und anschließend mit 2,5 g (110 mmol) Natrium versetzt. Bis zum Auflösen des Metalls wurde zum Rückfluß erhitzt und dann 4 Stunden bei Raumtemperatur nachgerührt. Nach Entfernen des Ethers wurde der Rückstand mit Toluol in einer Soxhletapparatur extrahiert: 6,7 g (90 %). Fp. 281°C aus Xylol.

5,4 g (10 mmol) Tetrakis-(biphenylyl-4)-silan wurden in 200 ml 1,2-Dichlorbenzol gelöst und unter Durchleitung von Stickstoff portionsweise mit 6,5 g (40 mmol) Eisen(III)chlorid versetzt. Innerhalb 3 Stunden wurde zum Sieden erhitzt. Als im Abgas kein HCI mehr als NH₄Cl nachweisbar war, wurde am Rotavapor eingeengt, der Rückstand mehrmals mit 5 gew.-%iger Salzsäure digeriert und der Rückstand aus Xylol unter Zusatz von 1 g Silicagel umkristallisiert: 2,7 g (51%).

### Beispiel 9:

### 2,2'-Dinitro-9,9'-spiro-9-sila-bifluoren

3,16 g (13 mmol) Cu(NO₃)₂ x 3 H₂O werden bei Raumtemperatur in 20 ml Essigsäureanhydrid aufgenommen und gerührt. Nach einigen Minuten steigt die Innentemperatur unter Eintrübung der blauen Suspension auf ca. 40 bis 45°C.

Anschließend werden 2 g (6 mmol) 9-Sila-9,9'-Spirobifluoren zugeführt und bei 40°C weitergeführt.
Nach 4 Stunden bei 40°C ist die Reaktion beendet. Farblich wechselte die Suspension dabei nach türkis. Es wird vorsichtig in ca. 100 ml Wasser eingerührt und mit Chloroform ausgeschüttelt. Nach Einrotieren der organischen Phase und Lösen des Rückstandes in wenig Chloroform wird die Lösung mit 100 ml Hexan ausgefällt: 2g farbloses Produkt (79%).

2,2',7,7'-Tetranitro-9,9'-spiro-9-sila-bifluoren kann bei veränderter Stöchiometrie auf analogem Wege als Hauptprodukt erhalten werden.

### Beispiel 10:

### 2,2'-Diamino-9,9'-spiro-9-sila-bifluoren

Eine Mischung aus 4,0 g Dinitro-spiro-9-sila-bifluoren und 4,0 g Eisenpulver wurden in 100 ml Ethanol unter Rückfluß erhitzt, während 15 ml konz. Salzsäure über einen Zeitraum von 30 min zugetropft wurden. Nach weiteren 30 min Kochen am Rückfluß wurde überschüssiges Eisen abfiltriert. Das grüne Filtrat wurde in eine Lösung aus 400 ml Wasser, 15 ml konz. NH₄OH-Lösung und 20 g Na,K-Tartrat gegeben. Das weiße Diamin wurde von der dunkelgrünen Lösung des Eisenkomplexes abfiltriert. Das Diamin wurde zur Reinigung in verdünnter Salzsäure gelöst und bei Raumtemperatur mit Aktivkohle (Darco) gerührt und abfiltriert. Die filtrierte Lösung wurde unter mechanischem Rühren (KPG-Rührer) tropfenweise mit NH₄OH-Lösung neutralisiert und das ausgefallene Produkt abgesaugt. Man erhielt 3,3 g weißes 2,2'-Diamino-9,9'-spiro-9-sila-bifluoren, das aus Ethanol umkristallisiert wurde.

2,2',7,7'-Tetraamino-9,9'-spiro-9-sila-bifluoren kann bei veränderter Stöchiometrie auf analogem Wege als Hauptprodukt erhalten werden.

### Beispiel 11:

### 2,2'-Dibrom-9,9'-spiro-9-sila-bifluoren

2,0 g (5,5 mmol) 2,2'-Diamino-9,9'-spiro-9-sila-bifluoren werden in 20 ml Wasser und 5 ml konz. Bromwasserstoffsäure gelöst, auf ca. 0°C gekühlt und langsam unter Einhaltung dieser Temperatur mit einer Lösung von 0,8 g NaNO₂ in ca. 5 ml Wasser versetzt. Man rührt bei dieser Temperatur ca. 30 min und gießt die Lösung des entstandenen Bisdiazoniumsalzes in eine eisgekühlte Lösung von 1 g CuBr in 10 ml HBr. Die entstandene Lösung wird bei 100°C gerührt, wobei man Gasentwicklung erkennt und das entstehende Produkt als weißer Niederschlag ausfällt. Nach Beendigung der Gasentwicklung wird das Produkt abgesaugt, mit NaHCO₃-Lösung neutral und mit Wasser salzfrei gewaschen. Anschließend wird aus Chloroform/Hexan umgefällt: 1,8 g farbloses Pulver (66%).

2,2',7,7'-Tetrabrom-9,9'-spiro-9-sila-bifluoren kann bei veränderter Stöchiometrie aus 2,2',7,7'-Tetraamino-9,9'-spiro-9-sila-bifluoren auf analogem Wege als Hauptprodukt erhalten werden.

### Beispiel 12:

### 9,9'-Spiro-9-sila-bifluoren-2,2'-dicarbonsäure aus 2,2'-Dibrom-9,9'-spiro-9-sila-bifluoren über 2,2'-Dicyano-9,9'-spiro-9-sila-bifluoren

1,18 g (2,4 mmol) 2,2'-Dibrom-9,9'-spiro-9-sila-bifluoren, gemäß Beispiel 11 und 0,54 g CuCN wurden in 5 ml DMF 6 Stunden zum Rückfluß erhitzt. Die erhaltene braune Mischung wurde in eine Mischung aus 3 g FeCl₃ (hydrat.) und 1,5 ml konz. Salzsäure in 20 ml Wasser gegossen. Die Mischung wurde 30 min bei 60 bis 70°C gehalten, um den Cu-Komplex zu zerstören. Die heiße, wäßrige Lösung wurde zweimal mit Toluol extrahiert. Die organischen Phasen wurden dann mit verdünnter Salzsäure, Wasser und 10 gew.-%iger wäßriger NaOH gewaschen. Die organische Phase wurde filtriert und eingeengt. Der erhaltene, gelbe Rückstand wurde aus Methanol umkristallisiert. Man erhielt 0,64 g (70 %) 2,2'-Dicyano-9,9'-spiro-9-sila-bifluoren als schwach gelbliche Kristalle (Schmelzbereich 230 bis 260°C).

3,82 g (10 mmol) 2,2'-Dicyano-9,9'-spiro-9-sila-bifluoren wurden mit 30ml 30 gew.-%iger NaOH und 40 ml Ethanol für 6 Stunden unter Rückfluß erhitzt. Das Dinatriumsalz der Spirosilabifluorendicarbonsäure fiel als gelber Niederschlag aus, der abfiltriert und in 25 gew.-%iger wäßriger HCI erhitzt wurde, um die freie Säure zu gewinnen. Die Spirosilabifluorendicarbonsäure wurde aus Eisessig umkristallisiert. Man erhielt 2,52 g (60 %) weiße Kristalle (Smp. > 360°C, IR-Bande 1685 cm⁻¹ C=O).

### Beispiel 13:

### 9,9'-Spiro-9-sila-bifluoren-2,2',7,7'-tetracarbonsäure wurde aus 2,2',7,7'-Tetrabrom-9,9'-spiro-9-sila-bifluoren in analoger Weise hergestellt.

### Beispiel 14:

### 2,2'-Bis(brommethyl)-9,9'-Spiro-9-sila-bifluoren aus 9,9'-Spiro-9-sila-bifluoren-2,2'-dicarbonsäure über 2,2'-Bis(hydroxymethyl)-9,9'-Spiro-9-sila-bifluoren in Analogie zu V. Prelog, D. Bedekovicc, Helv. Chim. Acta 1979, 62, 2285

Bei Raumtemperatur wurden 10 g einer 70 gew.-%igen Lösung von Natriumdihydrido-bis(2-methoxyethoxy)-aluminat (Fluka) in Toluol langsam zu einer Suspension von 2,08 g (5 mmol) 2,2'-Dicarboxy-9,9'-spiro-9-sila-bifluoren-2,2'-dicarbonsäure in 20 ml Toluol zugetropft. Nach 2 Stunden Kochen unter Rückfluß, wobei sich die Carbonsäure auflöste, wurde das überschüssige Reduktionsmittel bei 10°C mit Wasser zersetzt, das Gemisch mit konz. Salzsäure angesäuert und mit Chloroform ausgeschüttelt.

Die mit Wasser gewaschene und über Magnesiumsulfat getrocknete organische Phase wurde eingedampft und der Rückstand aus Benzol umkristallisiert. Man erhielt 1,7 g 9,9'-Spiro-9-sila-bifluoren-2,2'-dimethanol (Smp. > 250°C). Zu einer Lösung von 14 g 9,9'-Spiro-9-sila-bifluoren-2,2'-dimethanol in 400 ml Toluol wurden 92 g einer 33 gew.-%igen wäßrigen Lösung von Bromwasserstoff in Eisessig zugetropft und das Gemisch 7 Stunden unter Rückfluß gekocht. Danach wurde mit 200 ml Wasser versetzt und die mit Wasser gewaschene und über Magnesiumsulfat getrocknete organische Phase eingedampft. Die Chromatographie an Kieselgel mit Toluol liefert 11 g 2,2'-Bis(brommethyl)-9,9'-spiro-9-sila-bifluoren als farblose Plättchen.

### Beispiel 15:

Eine Lösung von 0,4 g 9,9'-Spiro-9-sila-bifluoren-2,2'-dimethanol, gemäß Beispiel 14, in 15 ml Toluol wurde mit 5 g Chrom(Vl)oxid auf Graphit (Seloxcette, Alpha Inorganics) versetzt und 48 Stunden unter Stickstoff am Rückfluß gekocht. Dann wurde durch eine Glasfilternutsche abgesaugt und das Filtrat eingedampft. Chromatographie an Kieselgel mit Chloroform und Kristallisation aus Methylenchlorid/Ether lieferte 150 mg 9,9'-Spiro-9-sila-bifluoren-2,2'-dicarbaldehyd (Smp.>300°C) und 200 mg 2'-Hydroxymethyl-9,9'-spiro-9-sila-bifluoren-2-carbaldehyd (Smp.> 260°C).

### Beispiel 16:

### 2,2'-Bis(benzofuran-2-yl)-9,9'-spiro-9-sila-bifluoren analog zu W.Sahm, E.Schinzel, P.Jürges, Liebigs Ann.Chem. 1974, 523.

2,7 g (22 mmol) Salicylaldehyd und 5,4 g (10 mmol) 2,2'-Bis(brommethyl)-9,9'-spiro-9-sila-bifluoren, gemäß Beispiel 14, wurden bei Raumtemperatur in 15 ml DMF gelöst und mit 0,9 g (22,5 mmol) pulverisiertem NaOH sowie einer Spatelspitze KJ versetzt. Man erhitzte zum Sieden und rührte 1 Stunde bei Siedetemperatur. Nach Abkühlung versetzte man die Reaktionslösung mit einem Gemisch aus 0,5 ml konz. Salzsäure, 7 ml Wasser und 7 ml Methanol. Man rührte noch 1 Stunde bei Raumtemperatur, saugte die kristallinen Reaktionsprodukte ab, wusch zunächst mit kaltem Methanol, dann mit Wasser und trocknete im Vakuum bei 60°C. Man erhielt 4,6 g (79 %) des Bisbenzylphenylethers.

6,0 g (10 mmol) des Bisbenzylphenylethers wurden in 10 ml Toluol mit 2,1 g (22,5 mmol) frisch destilliertem Anilin versetzt. Man gab eine Spatelspitze p-Toluolsulfonsäure zu und erhitzte am Wasserabscheider so lange zum Sieden, bis sich kein Wasser mehr abtrennte (ca. 3 bis 5 Stunden). Beim Abkühlen des Reaktionssatzes fiel das korrespondierende bis-Benzylidenphenylamin kristallin aus. Es wurde abgesaugt, mit Methanol gewaschen und im Vakuum bei 60°C getrocknet. Zur weiteren Reinigung kann aus DMF umkristallisiert werden. 7,5 g (10 mmol) des bis-Benzylidenphenylamins und 0,62 g (11 mmol) KOH werden unter Stickstoff in 30 ml DMF eingetragen. Anschließend erhitzt man unter Rühren 4 Stunden auf 100°C. Nach Abkühlung auf Raumtemperatur wurde der Niederschlag abgesaugt und mit wenig DMF und Wasser gewaschen. Nach Trocknen bei 60°C im Vakuumtrockenschrank wurde das 2,2'-Bis(benzofuran-2-yl)-9,9'-spiro-9-sila-bifluoren durch Umkristallisation aus Benzoesäuremethylester gereinigt.

### Beispiel 17:

### 2,2',7,7'-Tetrakis-(benzofuran-2-yl)-9,9'-spiro-9-sila-bifluoren

wurde bei entsprechend veränderter Stöchiometrie analog zu Beispiel 1 hergestellt.

### Beispiel 18:

### 2,2',7,7'-Tetraphenyl-9,9'-spiro-9-sila-bifluoren

5,1 g (7,9 mmol) 2,2',7,7'-Tetrabrom-9,9'-spiro-9-sila-bifluoren, 3,86 g (31,6 mmol) Phenylboronsäure, 331,5 mg (1,264 mmol) Triphenylphosphin und 70,9 mg (0,316 mmol) Palladiumacetat wurden in einer Mischung aus 65 ml Toluol und 40 ml wäßriger Natriumcarbonatlösung (2 M) aufgeschlämmt. Unter starkem Rühren wurde die Mischung 24 Stunden am Rückfluß gekocht. Nach Abkühlen auf Raumtemperatur wurde abgesaugt, mit Wasser gewaschen und bei 50°C im Vakuum getrocknet. Man erhielt 2,4 g Produkt. Das Filtrat wurde mit 50 ml Toluol extrahiert und die getrocknete organische Phase zur Trockne eingeengt. Man erhielt weitere 1,42 g Produkt.
Gesamtausbeute: 3,82 g (76 %)

### Beispiel 19:

### 2,2',7,7'-Tetrakis-(biphenyl-4-yl)-9,9'-spiro-9-sila-bifluoren

5,1 g (7,9 mmol) 2,2',7,7'-Tetrabromspiro-9-sila-bifluoren, 6,57 g (33,2 mmol) Biphenylylboronsäure, 331,5 mg (1,264 mmol) Triphenylphosphin und 70,9 mg (0,316 mmol) Palladiumacetat wurden in einer Mischung aus 65 ml Toluol und 40 ml wäßriger Natriumcarbonatlösung (2 M) aufgeschlämmt. Unter starkem Rühren wurde die Mischung 24 Stunden am Rückfluß gekocht. Nach Abkühlen auf Raumtemperatur wurde abgesaugt, mit Wasser gewaschen und bei 50°C im Vakuum getrocknet.
Ausbeute 5,87 g (79 %).

### Beispiel 20:

### Synthese von 2,2',7,7'-Tetrakis(biphenyl-4-yl)-9,9'-spiro-9-sila-bifluoren

In einem 250 ml Zweihalskolben mit Rückflußkühler und KPG-Rührer wurden 5,5 g 2,2',7,7'-Tetrabromspiro-9-sila-bifluoren, 7,2 g 4-Biphenylylboronsäure und 400 mg Tetrakis(triphenylphosphin)palladium(0), in einer Mischung aus 100 ml Toluol und 50 ml Kaliumcarbonatlösung aufgeschlämmt. Unter Rühren mit einem KPG-Rührer und Schutzgasüberlagerung wurde die Mischung 8 Stunden am Rückfluß gekocht. Nach Abkühlen wurde das Produkt abgesaugt, der Niederschlag mit Wasser gewaschen und getrocknet. Im Filtrat wurde die Toluol-Phase abgetrennt und die wäßrige Phase einmal mit Chloroform ausgeschüttelt. Die vereinigten organischen Phasen wurden über Natriumsulfat getrocknet und eingeengt, man erhielt so eine zweite Fraktion des Produktes. Die beiden Produktfraktionen wurden vereinigt (8g) und in Chloroform gelöst. Die Chloroformlösung wurde mit Aktivkohle aufgekocht und über eine kurze Säule mit Kieselgel filtriert. Nach dem Einengen und Umkristallisation aus Chloroform / Pentan erhielt man farblose, unter UV-Beleuchtung blau fluoreszierende Kristalle. Schmelzpunkt 408°C (DSC).
¹H-NMR (CDCl₃, ppm): 7.14 (d, J = 1,53 Hz, 4 H ); 7.75 (dd, J = 7.93, 1.53 Hz, 4 H); 8.01 (d, J = 7.93 Hz, 4 H); 7.34 (dd, J = 7.32, 1.37 Hz, 4 H); 7.42 (t, J = 7.32 Hz, 8 H); 7.58 (24 H).

### Beispiel 21:

### Synthese von 2,2'-Bis[(5(p-t-butylphenyl)-1,3,4-oxadiazol-2-yl]-9,9'-spiro-9-sila-bifluoren aus 9,9'-Spiro-9-sila-bifluoren-2,2'-dicarbonsäurechlorid und 5(4-t-Butylphenyl)tetrazol

21a) Synthese von 5-(4-t-Butylphenyl)tetrazol
   In einem 250 ml Rundkolben mit Rückflußkühler wurden 4,9 g *p*-*t*-Butylbenzonitril, 3,82 g Lithiumchlorid und 5,85 g Natriumazid und 8,2 g Triethylammoniumbromid in 100 ml DMF für 8 Stunden auf 120°C erhitzt. Nach Abkühlung auf Raumtemperatur wurde 100 ml Wasser zugesetzt und im Eisbad mit verdünnter Salzsäure versetzt, bis kein weiterer Niederschlag mehr ausfiel. Es wurde abgesaugt, der Niederschlag mit Wasser gewaschen und getrocknet. Umkristallisation aus Ethanol/Wasser lieferte 4,4 g farblose Kristalle.
21b) 9,9'-Spiro-9-sila-bifluoren-2,2'-dicarbonsäurechlorid
   In einem 100 ml Kolben mit Rückflußkühler und Trockenrohr wurden 2,1 g (5 mmol) 9,9'-Spiro-9-sila-bifluoren-2,2'-dicarbonsäure, gemäß Beispiel 12, mit 20 ml (frisch destilliertem Thionylchlorid) und 3 Tropfen DMF, 4 Stunden am Rückfluß gekocht. Nach Abkühlung wurde der Rückflußkühler gegen eine Destillationsbrücke ausgetauscht und überschüssiges Thionylchlorid im Vakuum abdestilliert. Dem Rückstand wurden 40 ml Petrolether (Siedepunkt: 30°-60°C) zugesetzt und abdestilliert, zurück blieb das kristalline Säurechlorid.
21c) 2,2'-Bis[(5-(*p*-*t*-butylphenyl)-1,3,4-oxadiazol-2yl]-9,9'-spiro-9-sila-bifluoren
   Dem Säurechlorid wurden gemäß Beispiel 21.b 2,0 g (11 mmol) 5-(4-*t*-Butylphenyl)tetrazol gelöst in 20 ml wasserfreiem Pyridin, zugesetzt und unter Schutzgas 2 Stunden zum Rückfluß erhitzt. Nach Abkühlen wurde die Mischung in 200 ml Wasser gegeben und 2 Stunden stehen gelassen. Das ausgefallene Oxadiazolderivat wurde abgesaugt, mit Wasser gewaschen und im Vakuum getrocknet. Anschließend wurde über Kieselgel mit Chloroform/Essigester (99:1) chromatographiert und aus Chloroform/Pentan umkristallisiert. Man erhielt 2,3 g farblose Kristalle.

### Beispiel 22:

2,2',7,7'-Tetrakis-(biphenyl-4-yl)-9,9'-spiro-9-sila-bifluoren; gemäß Beispiel 19 wurde in Chloroform gelöst (30 mg/ml) und mittels Spincoating (1000 upm) auf einen mit Indium/Zinn-Oxid (ITO) beschichteten Glasträger aufgebracht, wobei ein homogener, transparenter Film gebildet wurde. Auf diesen Film wurde durch Vakuumbedampfung eine Elektrode aus Mg/Ag (80/20) aufgebracht. Beim Anlegen einer elektrischen Spannung zwischen der ITO-Elektrode und der Metallelektrode, wobei die Metallelektrode negativ gegenüber der ITO-Elektrode gepolt ist, wurde eine blaue Elektrolumineszenz beobachtet.

### Beispiel 23:

Gemäß Beispiel 22 wurden weitere Meßzellen durch Aufdampfen im Vakuum auf eine ITO-Schicht (30 Ohm) hergestellt, wobei folgende Parameter erhalten wurden:
Dicke der 2,2'7,7'-Tetrakis-(biphenyl-4-yl)-9,9'-spiro-9-sila-bifluoren-Schicht a₁ = 60 nm,
Dicke der Aluminiumtris(8-oxychinolin)-Schicht: b₁ = 20 nm,
Dicke der Al + Mg (3%)-Schicht: c₁ = 135 nm,
Analoge Meßzelle: a₂ = 60 nm, b₂ = 0 nm,
a₃ = 41 nm, b₃ = 150 nm.
Alle drei Meßzellen zeigten blaue Elektrolumineszenz.

## Patentansprüche

1. Verwendung von Heterospiroverbindungen der allgemeinen Formel (I), 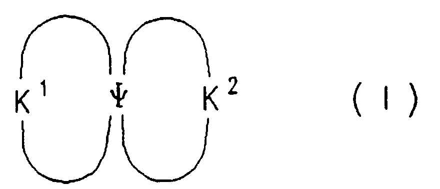 wobei
ψ ein Element der 4. Hauptgruppe des Periodensystems mit Ausnahme von Kohlenstoff bedeutet und
K¹ und K² unabhängig voneinander konjugierte Systeme bedeuten, in Elektrolumineszenzvorrichtungen.

2. Verwendung nach Anspruch 1, dadurch gekennzeichnet, daß eine Heterospiroverbindung der allgemeinen Formel (II) eingesetzt wird, 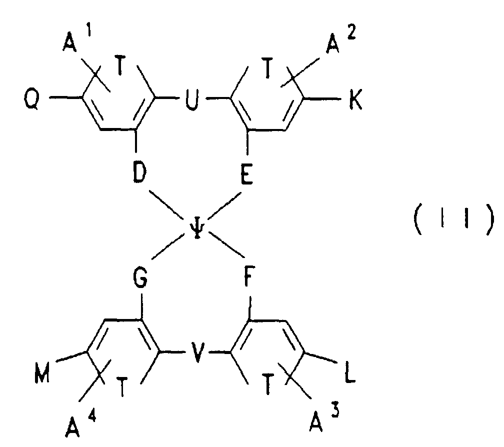 wobei die Symbole und Indizes folgende Bedeutungen haben:
ψ ist Si, Ge, Sn;
D, E, F, G sind gleich oder verschieden -CR¹R²-, -O-, -S-, -NR³- oder eine chemische Bindung;
U, V sind gleich oder verschieden -CR¹R²-, -O-, -S-, -NR³-, -SiR¹R²-, -SO₂-, -CO-, -CR⁴=CR⁵- oder eine chemische Bindung, mit der Maßgabe, daß entweder U oder V -CR⁴=CR⁵- oder eine chemische Bindung ist;
T ist -O-, -S-, -NR³-, -CR¹R²-, -CH=N-, -CA⁵=CA⁶-, -CH =CA⁷-;
K, L, M, Q sind gleich oder verschieden, cyclische oder acyclische Kohlenwasserstoffreste, die auch Heteroatome enthalten können und durch konjugierte Elektronensysteme gekennzeichnet sind;
A¹, A², A³, A⁴ können gleich oder verschieden, die gleichen Bedeutungen wie K, L, M, Q haben oder sind Wasserstoff, Fluor oder ein Kohlenwasserstoffrest mit 1 bis 22 C-Atomen, der auch Heteroatome enthalten kann;
R¹, R², R³ sind gleich oder verschieden H oder ein Kohlenwasserstoffrest mit 1 bis 12 C-Atomen, wobei R¹ und R² zusammenn auch einen unsubstituierten oder substituierten Ring bilden können;
R⁴, R⁵ haben, gleich oder verschieden, die gleichen Bedeutungen wie R¹, R², R³ oder sind Fluor oder -CF₃;
R⁶, R⁷ sind gleich oder verschieden H oder ein Kohlenwasserstoffrest mit 1 bis 22 C-Atomen, der aliphatisch oder aromatisch, linear oder verzweigt sein kann und auch alicyclische Elemente enthalten kann, oder R⁶ und R⁷ bilden zusammen einen Cyclus;
Ar ist ein aromatischer Rest mit bis zu 22 C-Atomen, wobei jeder dieser aromatischen Reste mit einem oder zwei Gruppen R⁴, R⁵ substituiert sein kann;
Q und A¹, K und A², L und A⁴, M und A³ können auch jeweils zu einem Ring zusammengeschlossen sein, der gesättigt, partiell ungesättigt oder maximal ungesättigt sein kann.

3. Verwendung nach Anspruch 1 und/oder 2, dadurch gekennzeichnet, daß eine Heterospiroverbindung der Formel (III) eingesetzt wird, 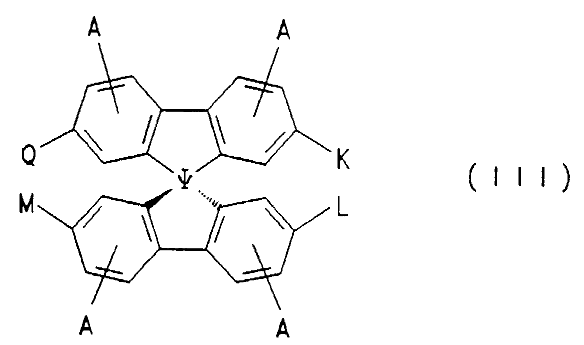 wobei die Symbole und Indizes folgende Bedeutungen haben:
ψ Si oder Ge;
K, L, M, Q, A sind gleich oder verschieden 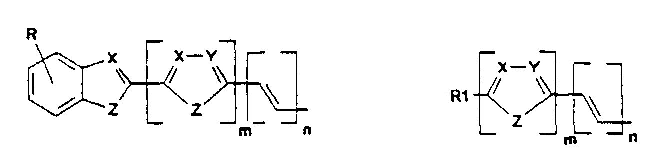 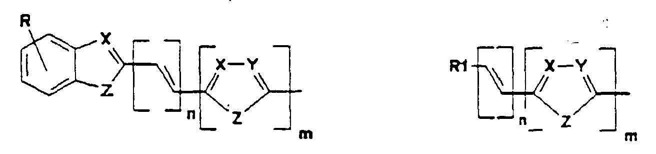 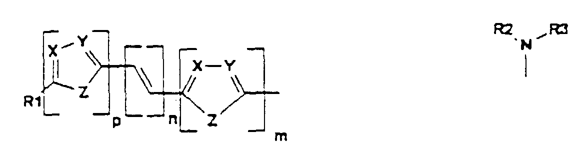
und
A kann auch, gleich oder verschieden die gleichen Bedeutungen wie R haben;
R kann, gleich oder verschieden, die gleichen Bedeutungen wie K, L, M, Q haben oder ist -H, eine lineare oder verzweigte Alkyl, Alkoxy oder Estergruppe mit 1 bis 22 C-Atomen, -CN, -NO₂, -NR²R³, -Ar oder -O-Ar;
Ar ist Phenyl, Biphenyl, 1-Naphthyl, 2-Naphthyl, 2-Thienyl, 2-Furanyl, wobei jede dieser Gruppen einen oder zwei Reste R tragen kann;
m, n, p sind unabhängig voneinander, gleich oder verschieden 0, 1, 2 oder 3;
X, Y sind gleich oder verschieden CR, N;
Z ist -O-, -S-, -NR¹-, -CR¹R⁴-, -CH=CH-, -CH=N-;
R¹, R⁴ können, gleich oder verschieden, die gleichen Bedeutungen wie R haben;
R², R³ sind gleich oder verschieden H, eine lineare oder verzweigte Alkylgruppe mit 1 bis 22 C-Atomen, -Ar, 3-Methylphenyl.

4. Verwendung nach einem oder mehreren der Ansprüche 1 bis 3, dadurch gekennzeichnet, daß ein Heterospirobifluorenderivat der Formeln (IIIa) bis (IIIg) eingesetzt wird,
IIIa) K = L = M = Q und ist aus der Gruppe: 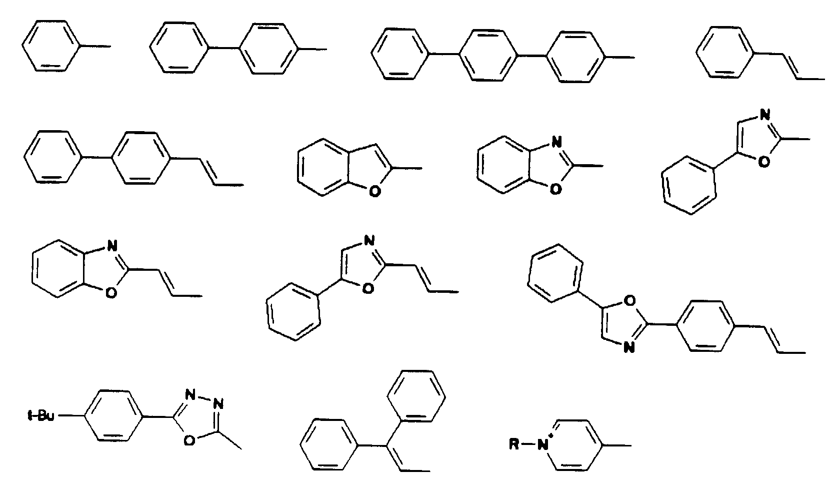 R = C₁-C₂₂-Alkyl, (CH₂)ₓ-SO₃⁻ mit x = 2, 3 oder 4
Illb) K = M = H und Q = L und ist aus der Gruppe: 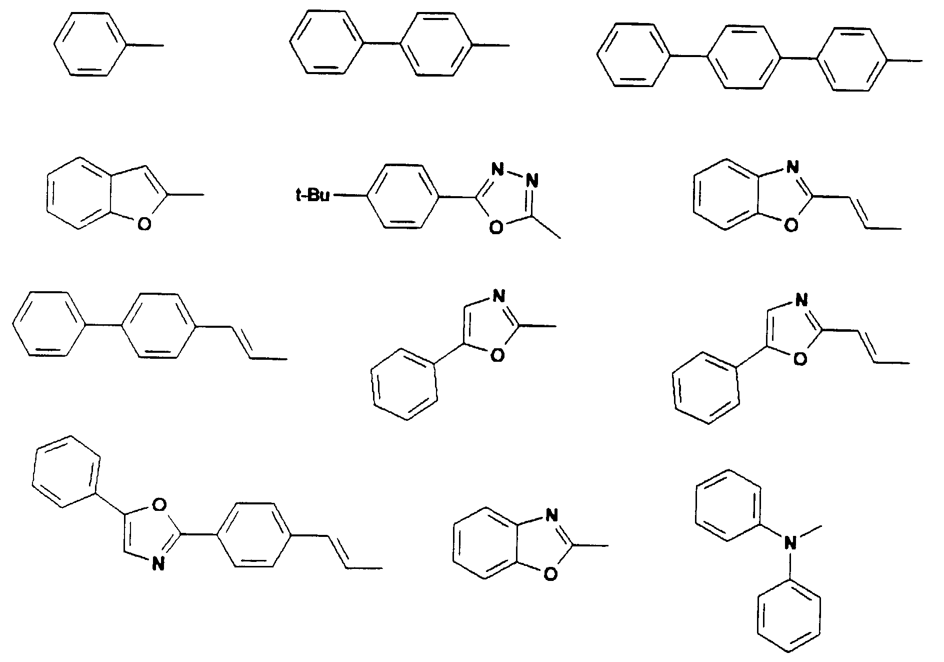
IIIc) K = M und ist aus der Gruppe: 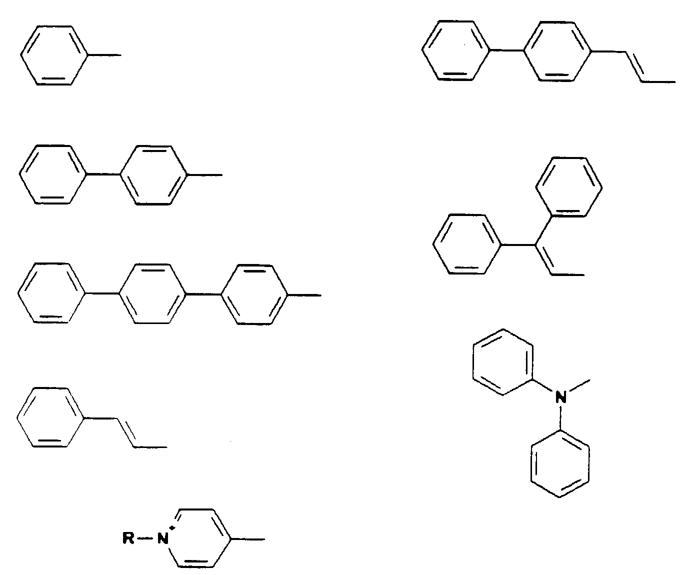 R = C₁-C₂₂-Alkyl, (CH₂)ₓ-SO₃⁻ mit x = 2, 3 oder 4
und Q = L und ist aus der Gruppe: 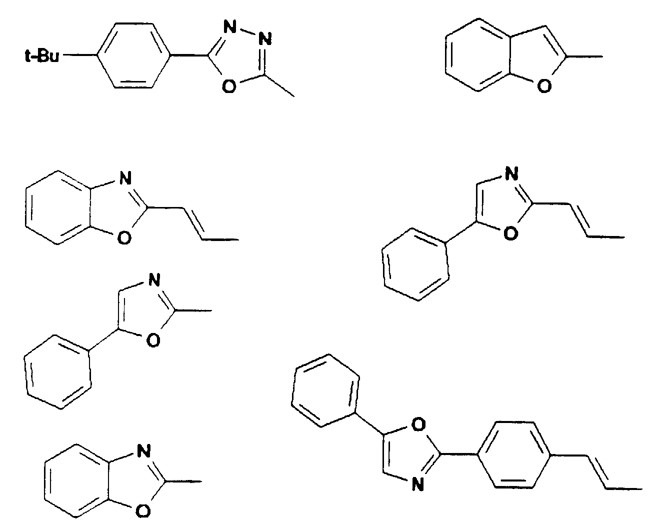
IIId) K = M und ist aus der Gruppe: 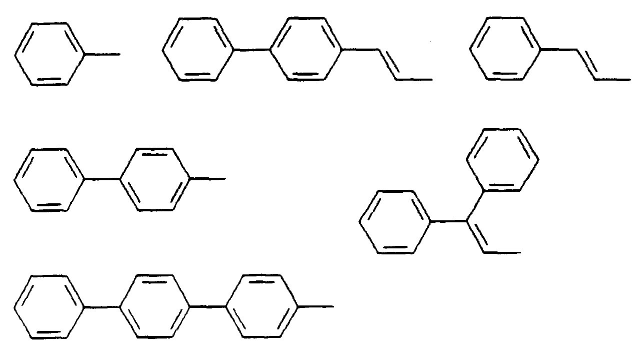 und Q = L und ist aus der Gruppe: 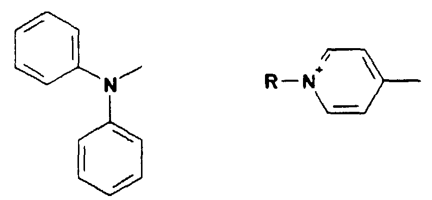 R = C₁-C₂₂-Alkyl, (CH₂)ₓ-SO₃⁻ mit x = 2, 3 oder 4
Ille) K = L = H und M = Q und ist aus der Gruppe: 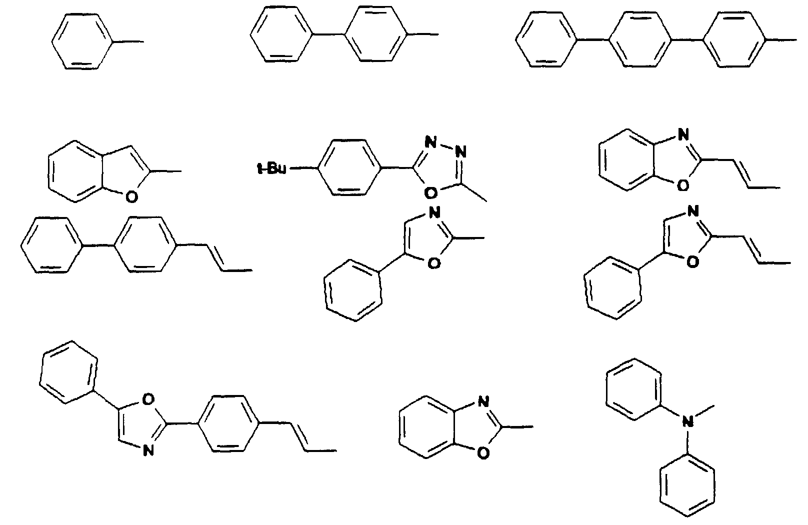
Illf) K = M und ist aus der Gruppe: 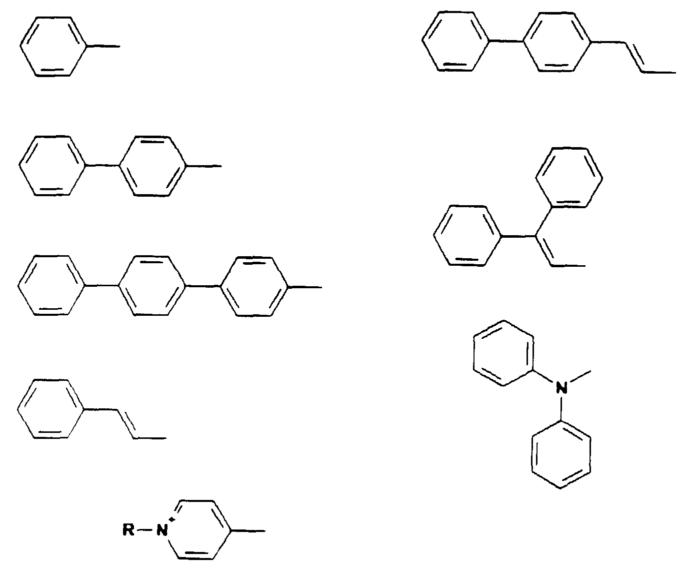 R = C₁-C₂₂-Alkyl, (CH₂)ₓ-SO₃⁻ mit x = 2, 3 oder 4
und M = Q und ist aus der Gruppe: 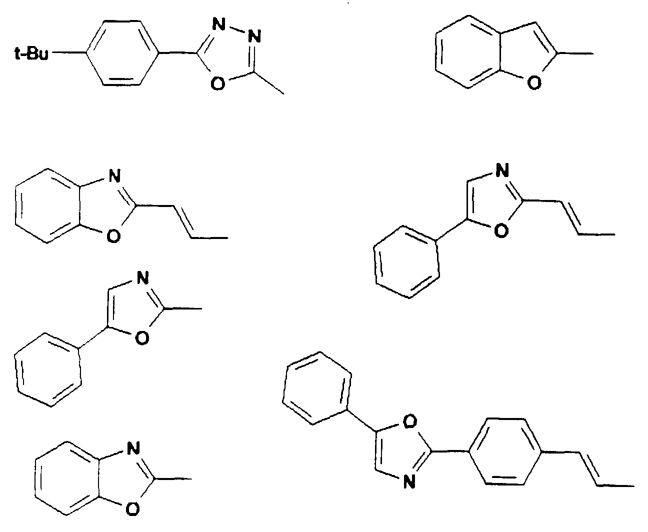
IIIg) K = L und ist aus der Gruppe: 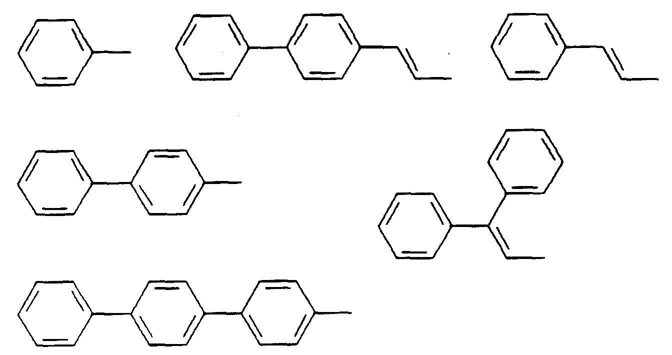 und M = Q und ist aus der Gruppe: 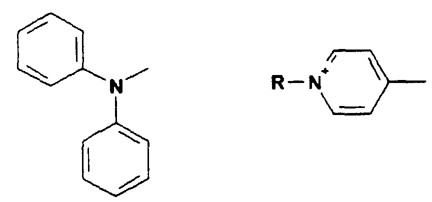 R = C₁-C₂₂-Alkyl, (CH₂)ₓ-SO₃⁻ mit x = 2, 3 oder 4

5. Heterospiroverbindung der Formel (IV), 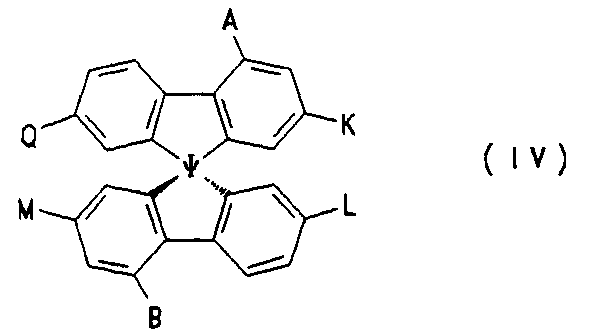 wobei die Symbole folgende Bedeutungen haben:
ψ ist Si, Ge oder Sn;
A, B, K, L, M, Q sind gleich oder verschieden 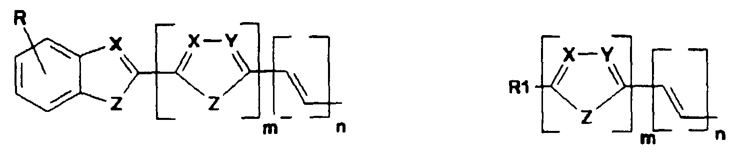 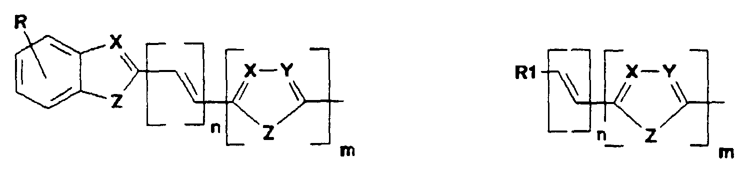 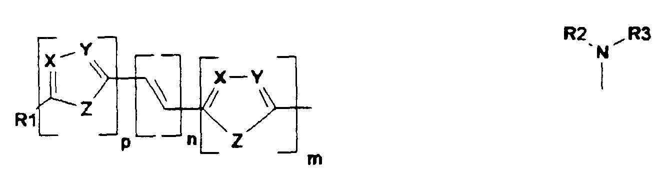
und
A, B können auch gleich oder verschieden eine lineare oder verzweigte Alkyl-, Alkyloxy- oder Estergruppe mit 1 bis 22 C-Atomen, -CN, -NO₂, -Ar oder -O-Ar sein;
R ist -H, eine lineare oder verzweigte Alkyl, Alkoxy oder Estergruppe mit 1 bis 22 C-Atomen, -CN, -NO₂, -NR²R³, -Ar oder -O-Ar;
Ar ist Phenyl, Biphenyl, 1-Naphthyl, 2-Naphthyl, 2-Thienyl, 2-Furanyl, wobei jede dieser Gruppen einen oder zwei Reste R tragen kann;
m, n, p sind unabhängig voneinander, gleich oder verschieden 0, 1, 2 oder 3;
X, Y sind gleich oder verschieden CR, N;
Z ist -O-, -S-, -NR¹-, -CR¹R⁴-, -CH=CH-, -CH=N-;
R¹, R⁴ können, gleich oder verschieden, die gleichen Bedeutungen wie R haben;
R², R³ sind gleich oder verschieden H, eine lineare oder verzweigte Alkylgruppe mit 1 bis 22 C-Atomen, -Ar oder 3-Methylphenyl.

6. Verwendung nach einem oder mehreren der Ansprüche 1 bis 4, dadurch gekennzeichnet, daß die Heterospiroverbindung als lichtemittierende Schicht dient.

7. Verwendung nach einem oder mehreren der Ansprüche 1 bis 4, dadurch gekennzeichnet, daß die Heterospiroverbindung als Transportschicht dient.

8. Verwendung nach einem oder mehreren der Ansprüche 1 bis 4, dadurch gekennzeichnet, daß die Heterospiroverbindung zur Ladungsinjektion dient.

9. Elektrolumineszenzmaterial, enthaltend eine oder mehrere Heterospiroverbindungen der Formeln (I) bis (III) in den Ansprüchen 1 bis 4.

10. Elektrolumineszenzvorrichtung, enthaltend eine aktive Schicht, die eine oder mehrere Heterospiroverbindungen der Formeln (I) bis (III) nach einem oder mehreren der Ansprüche 1 bis 4 enthält.

11. Elektrolumineszenzvorrichtung nach Anspruch 9, dadurch gekennzeichnet, daß die aktive Schicht eine lichtemittierende Schicht ist.

12. Elektrolumineszenzvorrichtung nach Anspruch 9, dadurch gekennzeichnet, daß die aktive Schicht eine Transportschicht ist.

13. Elektrolumineszenzvorrichtung nach Anspruch 9, dadurch gekennzeichnet, daß die aktive Schicht eine Ladungsinjektionsschicht ist.

## Claims

1. The use of a hetero-spiro compound of the formula (I), 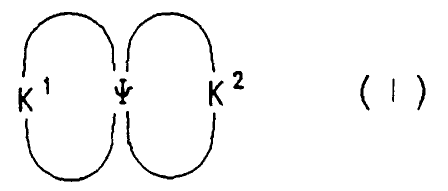 where
Ψ is an element of the 4th main group of the Periodic Table with the exception of carbon, and
K¹ and K² are, independently of one another, conjugated systems,
in an electroluminescence device.

2. The use as claimed in claim 1, wherein the hetero-spiro compound used has the formula (II), 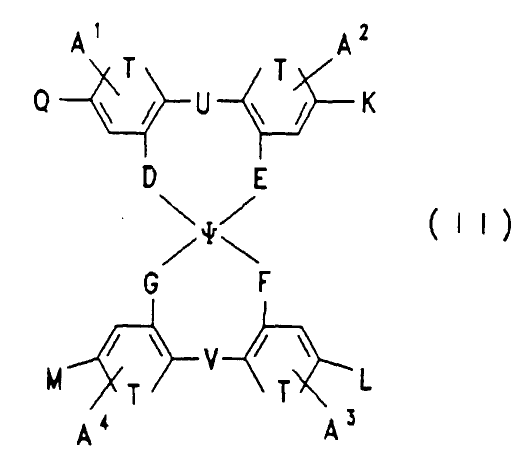 where the symbols and indices have the following meanings:
Ψ is Si, Ge, Sn;
D, E, F, G are identical or different and are -CR¹R²-, -O-, -S-, -NR³- or a chemical bond;
U, V are identical or different and are -CR¹R²-, -O-, -S-, -NR³-, -SiR¹R²-,-SO₂-, -CO-, -CR⁴=CR⁵- or a chemical bond, with the proviso that either U or V is -CR⁴=CR⁵- or a chemical bond;
T is -O-, -S-, -NR³-, -CR¹R²-, -CH=N-, -CA⁵=CA⁶-, -CH=CA⁷-;
K, L, M, Q are identical or different, cyclic or acyclic hydrocarbon radicals which can also contain heteroatoms and have conjugated electron systems;
A¹, A², A³, A⁴ can be identical or different and have the same meanings as K, L, M, Q or are hydrogen, fluorine or a hydrocarbon radical having from 1 to 22 carbon atoms which can also contain heteroatoms;
R¹, R², R³ are identical or different and are H or a hydrocarbon radical having from 1 to 12 carbon atoms, where R¹ and R² can together also form an unsubstituted or substituted ring;
R⁴, R⁵ are identical or different and have the same meanings as R¹, R², R³ or are fluorine or -CF₃;
R⁶, R⁷ are identical or different and are H or a hydrocarbon radical having from 1 to 22 carbon atoms which can be aliphatic or aromatic, linear or branched and can also contain alicyclic elements, or R⁶ and R⁷ together form a ring;
Ar is an aromatic radical having up to 22 carbon atoms, where each of these aromatic radicals can be substituted by one or two groups R⁴, R⁵;
Q and A¹, K and A², L and A⁴, M and A³ can also each be joined to form a ring which can be saturated, partially unsaturated or have maximum unsaturation.

3. The use as claimed in claim 1 or 2, wherein the hetero-spiro compound used has the formula (III), 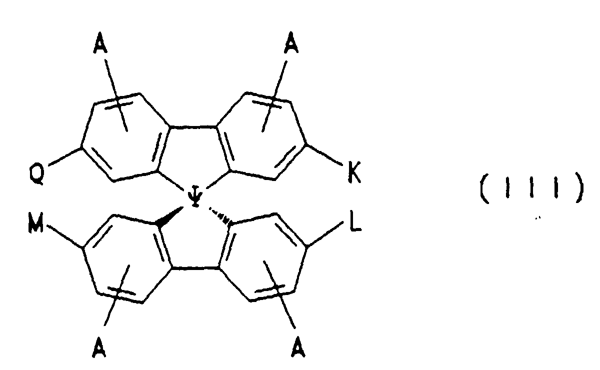 where the symbols and indices have the following meanings:
Ψ is Si or Ge;
K, L, M, Q, A are identical or different and are 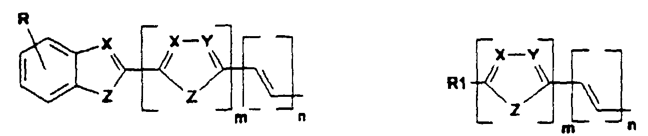 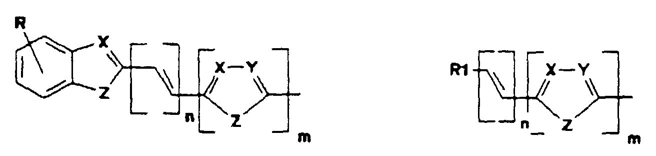 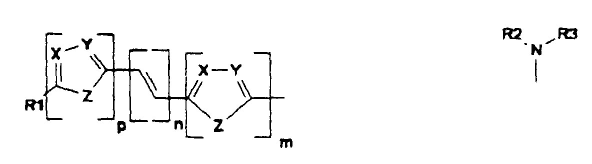
and
A can also be identical or different and have the same meanings as R;
R can be identical or different and have the same meanings as K, L, M, Q or is -H, a linear or branched alkyl, alkoxy or ester group having from 1 to 22 carbon atoms, -CN,-NO₂, -NR²R³, -Ar or -O-Ar;
Ar is phenyl, biphenyl, 1-naphthyl, 2-naphthyl, 2-thienyl, 2-furanyl, where each of these groups can bear one or two radicals R;
m, n, p are, independently of one another, identical or different and are 0, 1, 2 or 3;
X, Y are identical or different and are CR, N;
Z is -O-, -S-, -NR¹-, -CR¹R⁴-, -CH=CH- , -CH=N-;
R¹, R⁴ can be identical or different and have the same meanings as R;
R², R³ are identical or different and are H, a linear or branched alkyl group having from 1 to 22 carbon atoms,-Ar, 3-methylphenyl.

4. The use as claimed in one or more of claims 1 to 3, wherein the hetero-spiro compound used is a heterospirobifluorene derivative of the formulae (IIIa) to (IIIg),
IIIa) K = L = M = Q and is selected from the group consisting of: 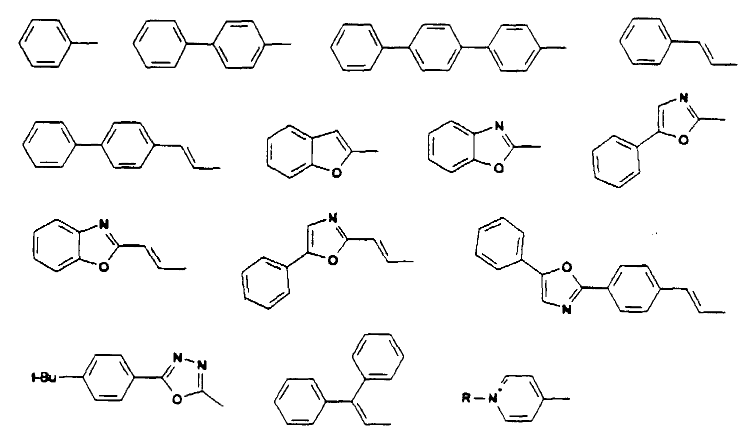 R = C₁-C₂₂-alkyl, (CH₂)ₓ-SO₃⁻ where x = 2, 3 or 4
IIIb) K *=* M = H and Q = L and are selected from the group consisting of: 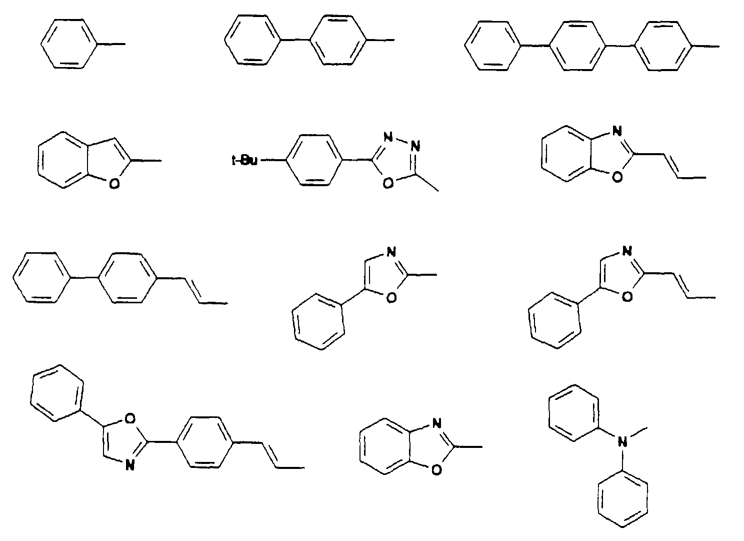
IIIc) K = M and is selected from the group consisting of: 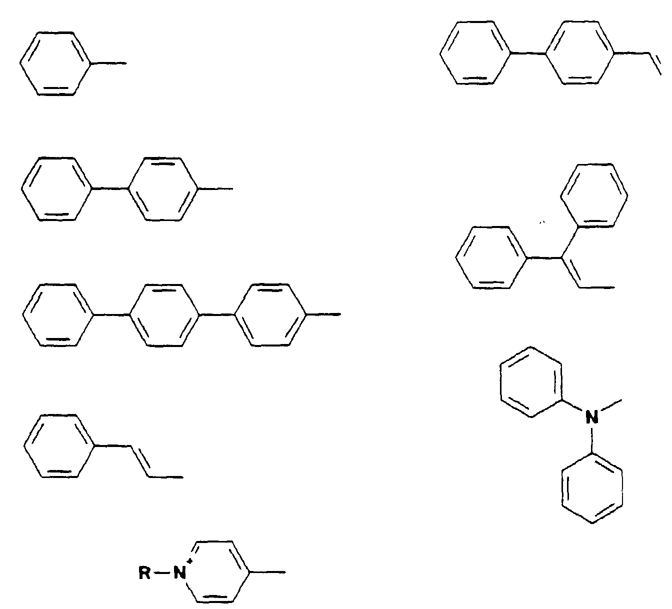 R = C₁-C₂₂-alkyl, (CH₂)ₓ-SO₃⁻ where x = 2, 3 or 4
and Q = L and is selected from the group consisting of: 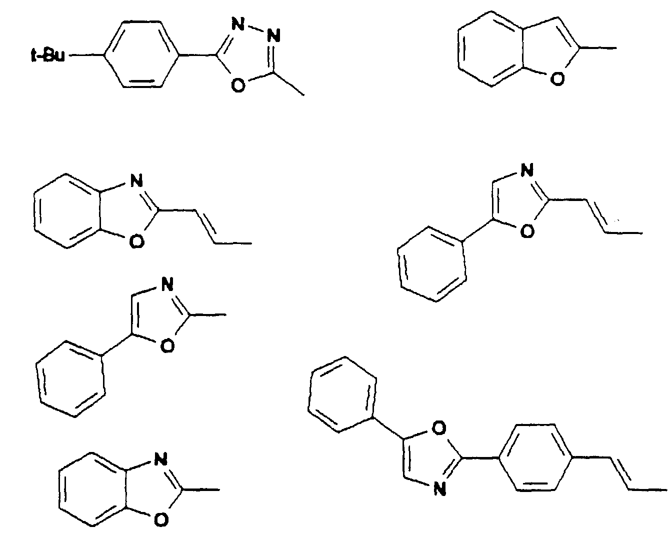
IIId) K = M and is selected from the group consisting of: 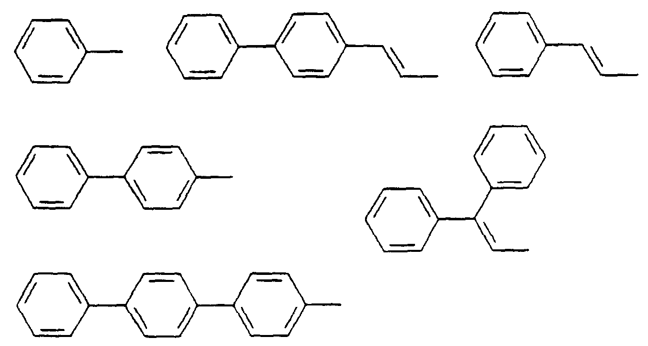 and Q = L and is selected from the group consisting of: 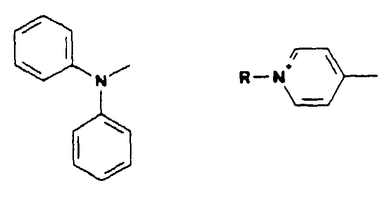 R = C₁-C₂₂-alkyl, (CH₂)ₓ-SO₃⁻ where x = 2, 3 or 4
IIIe) K = L = H and M = Q and are selected from the group consisting of: 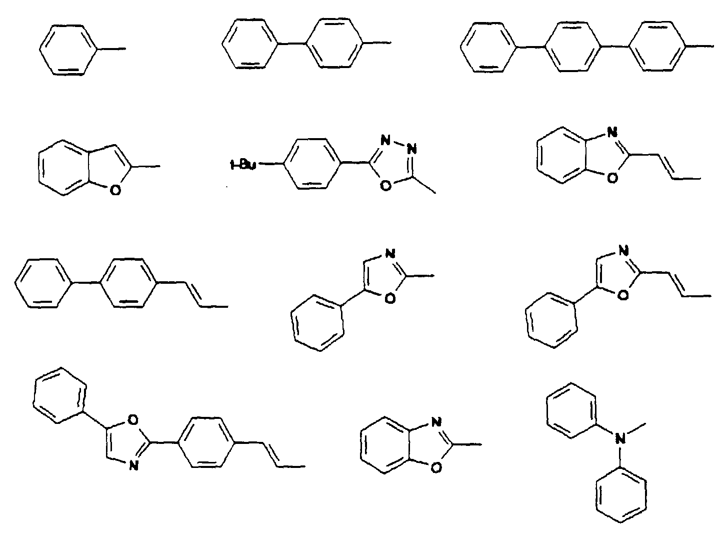
IIIf) K = M and is selected from the group consisting of: 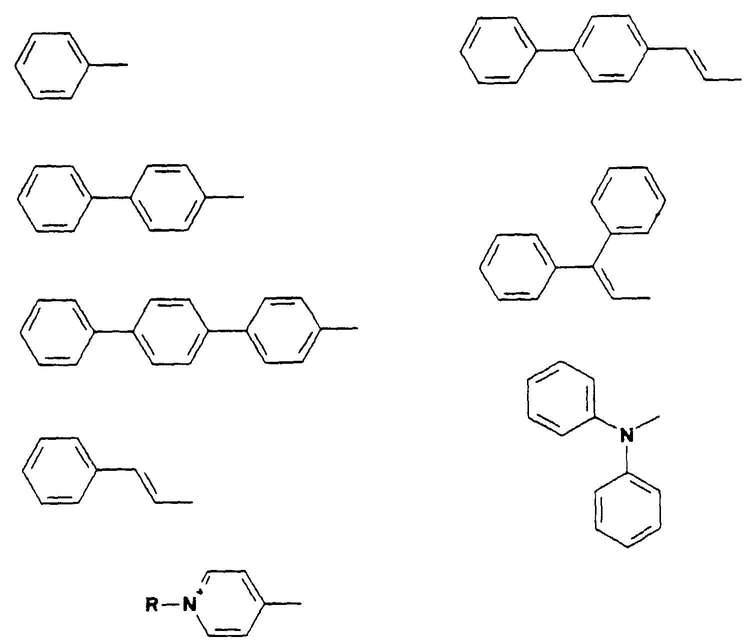 R = C₁-C₂₂-alkyl, (CH₂)ₓ-SO₃⁻ where x = 2, 3 or 4
and M = Q and is selected from the group consisting of: 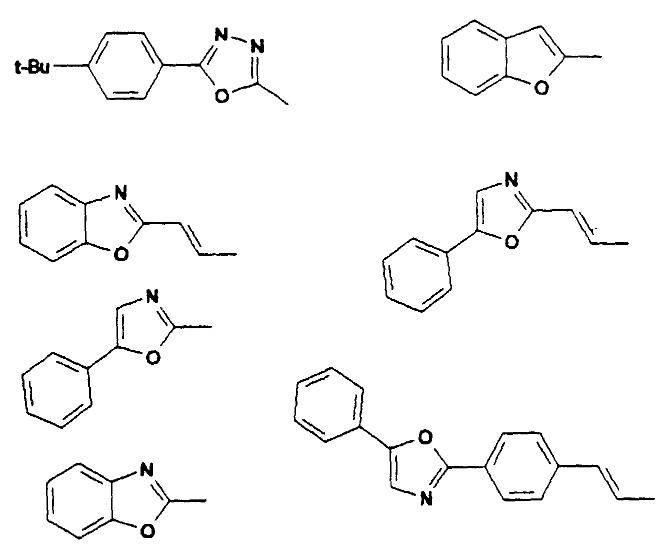
IIIg) K = L and is selected from the group consisting of: 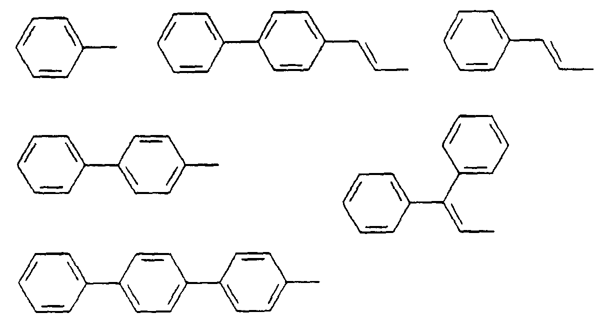 and M = Q and is selected from the group consisting of: 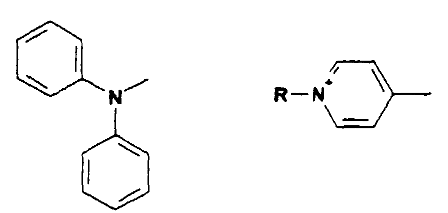 R = C₁-C₂₂-alkyl, (CH₂)ₓ-SO₃⁻ where x = 2, 3 or 4

5. A hetero-spiro compound of the formula (IV), 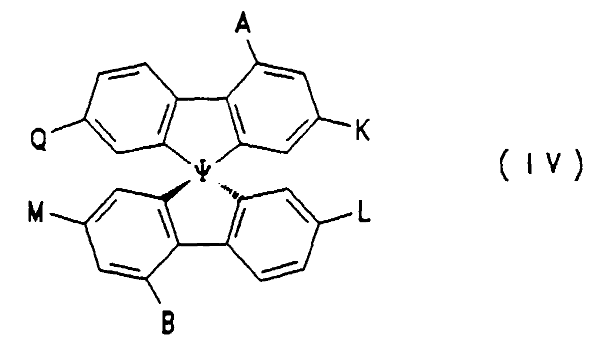 where the symbols have the following meanings:
Ψ is Si, Ge or Sn;
A, B, K, L, M, Q are identical or different and are 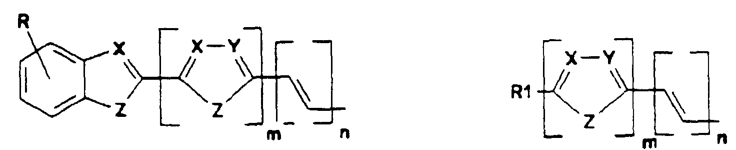 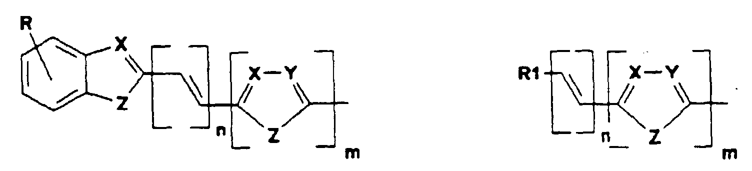 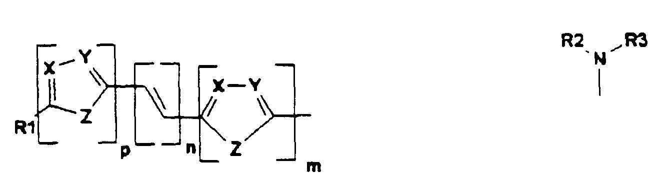
and
A, B can also be identical or different and each be a linear or branched alkyl, alkoxy or ester group having from 1 to 22 carbon atoms, -CN,-NO₂, -Ar or -O-Ar;
R is -H, a linear or branched alkyl, alkoxy or ester group having from 1 to 22 carbon atoms,-CN, -NO₂, -NR²R³, -Ar or -O-Ar;
Ar is phenyl, biphenyl, 1-naphthyl, 2-naphthyl, 2-thienyl, 2-furanyl, where each of these groups can bear one or two radicals R;
m, n, p are, independently of one another, identical or different and are 0, 1, 2 or 3;
X, Y are identical or different and are CR, N;
Z is -O-, -S-, -NR¹-, -CR¹R⁴-, -CH=CH-,-CH=N-;
R¹, R⁴ can be identical or different and have the same meanings as R;
R², R³ are identical or different and are H, a linear or branched alkyl group having from 1 to 22 carbon atoms, -Ar or 3-methylphenyl.

6. The use as claimed in one or more of claims 1 to 4, wherein the hetero-spiro compound serves as light-emitting layer.

7. The use as claimed in one or more of claims 1 to 4, wherein the hetero-spiro compound serves as transport layer.

8. The use as claimed in one or more of claims 1 to 4, wherein the hetero-spiro compound serves for charge injection.

9. An electroluminescence material comprising one or more hetero-spiro compounds of the formulae (I) to (III) in claims 1 to 4.

10. An electroluminescence device comprising an active layer comprising one or more hetero-spiro compounds of the formulae (I) to (III) as claimed in one or more of claims 1 to 4.

11. An electroluminescence device as claimed in claim 9, wherein the active layer is a light-emitting layer.

12. An electroluminescence device as claimed in claim 9, wherein the active layer is a transport layer.

13. An electroluminescence device as claimed in claim 9, wherein the active layer is a charge injection layer.

## Revendications

1. Utilisation des composés héterospiro de formule générale (I) : 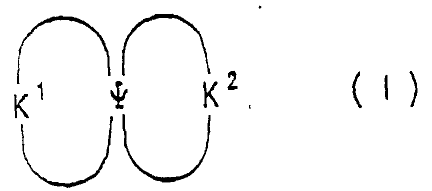 où
Ψ représente un élément du groupe 4 du tableau périodique à l'exception du carbone et
K¹ et K² représentent, indépendamment l'un de l'autre, des systèmes conjugués, dans des dispositifs d'électro-luminescence.

2. Utilisation selon la revendication 1, caractérisée en ce qu'on utilise un composé héterospiro de formule générale (II) : 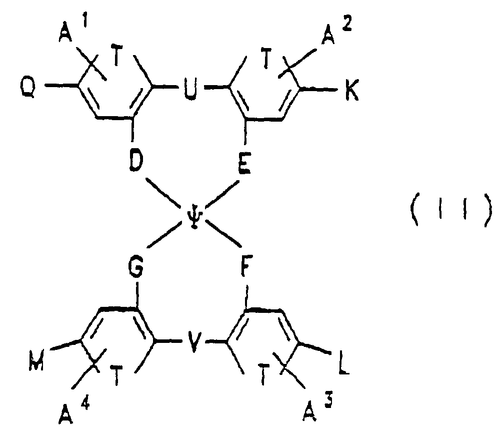 les symboles et les indices ayant les significations suivantes :
Ψ est Si, Ge, Sn ;
D, E, F, G sont identiques ou différentes et représentent -CR¹R²-, -O-, -S-, -NR³- ou une liaison chimique ;
U, V sont identiques ou différents et représentent -CR¹R²-, -O-, -S-, -NR³-, -SiR¹R²-, -SO₂-, -CO-, -CR⁴=CR⁵- ou une liaison chimique, à la condition que soit U, soit V représente -CR⁴=CR⁵- ou une liaison chimique ;
T représente -O-, -S-, -NR³-, -CR¹R²- , -CH=N-, -CA⁵=CA⁶-, -CH=CA⁷-;
K, L, M, Q sont identiques ou différents et représentent des restes hydrocarbonés cycliques ou acycliques, qui peuvent contenir aussi des héteroatomes et sont caractérisés par des systèmes électroniques conjugués ;
A¹, A², A³, A⁴ sont identiques ou différents et peuvent avoir les mêmes significations que K, L, M, Q ou représentent un atome d'hydrogène, de fluor ou un reste hydrocarboné avec de 1 à 22 atomes de carbone, qui peut contenir aussi des héteroatomes ;
R¹, R², R³ sont identiques ou différents et représentent un atome d'hydrogène ou un reste hydrocarboné avec de 1 à 22 atomes de carbone, R¹ et R² ensemble pouvant former aussi un cycle non substitué ou substitué ;
R⁴, R⁵ identiques ou différents, ont les mêmes significations que R¹, R², R³ ou représentent un atome de fluor ou un groupe -CF₃ ;
R⁶, R⁷ sont identiques ou différents et représentent un atome d'hydrogène ou un reste hydrocarboné avec de 1 à 22 atomes de carbone, qui peut être aliphatique ou aromatique, linéaire ou ramifié et peut contenir aussi des éléments alicycliques, ou R⁶ et R⁷ forment ensemble un cycle,
Ar est un reste aromatique avec jusqu'à 22 atomes de carbone, chacun de ces restes aromatiques pouvant être substitué par un ou deux groupes R⁴, R⁵ ;
Q et A¹, K et A², L et A⁴, M et A³ peuvent aussi chacun former un cycle qui peut être saturé, partiellement insaturé ou totalement insaturé.

3. Utilisation selon la revendication 1 et/ou 2, caractérisée en ce qu'on utilise un composé héterospiro de formule (III), 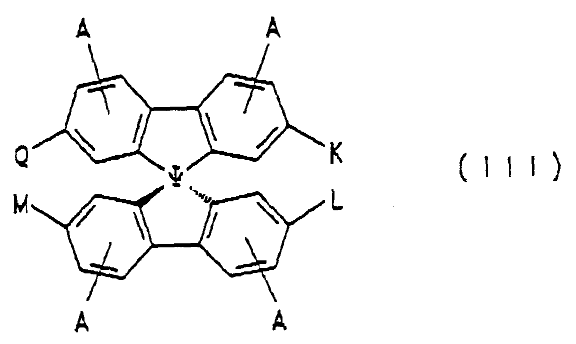 les symboles et les indices ayant les significations suivantes :
Ψ représente Si ou Ge ;
K, L, M, Q, A sont identiques ou différents 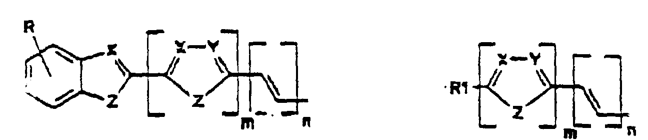 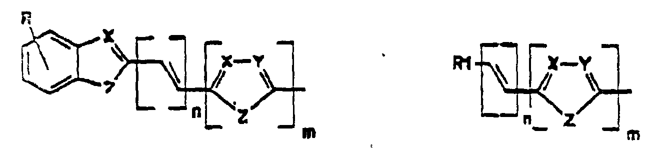 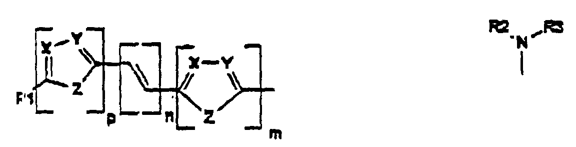
et les symboles A, identiques ou différents, peuvent avoir aussi les mêmes significations que R ;
R identiques ou différents, peuvent avoir les mêmes significations que K, L, M, Q ou représentent un atome d'hydrogène, un groupe ester, alcoxy ou alkyle linéaire ou ramifié avec de 1 à 22 atomes de carbone, -CN, -NO₂, -NR²R³, Ar ou -O-Ar ;
Ar est un groupe phényle, biphényle, 1-naphtyle, 2-naphtyle, 2-thiényle, 2-furanyle, chacun de ces groupes pouvant porter un ou deux restes R,
m, n, p sont indépendant l'un de l'autre, identiques ou différents, et valent 0, 1, 2 ou 3 ;
X, Y sont identiques ou différents, et représentent CR, N ;
Z représente -O-, -S-, -NR¹-, -CR¹R⁴-, -CH=CH-, -CH=N- ;
R¹, R⁴ identiques ou différents, peuvent avoir les mêmes significations que R
R², R³ sont identiques ou différents et représentent un atome d'hydrogène, un groupe alkyle linéaire ou ramifié avec de 1 à 22 atomes de carbone, -Ar, 3-méthylphényle.

4. Utilisation selon une ou plusieurs des revendications 1 à 3, caractérisée en ce qu'on utilise un dérivé hétérospiro de bifluorène de formule (IIIa) à (IIIg),
IIIa) K = L = M = Q et sont pris dans le groupe 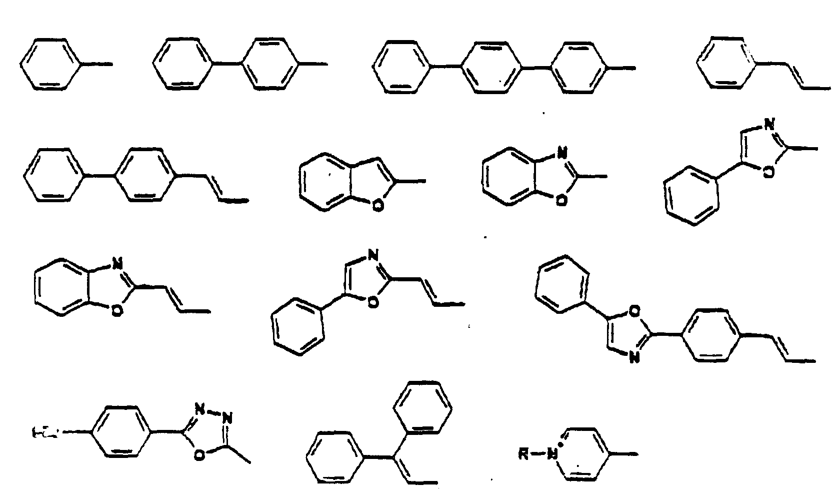 R = alkyle en C₁-C₂₂, (CH₂)ₓ-SO₃⁻ avec x = 2, 3 ou 4
IIIb) K = M = H et Q = L, et sont pris dans le groupe : 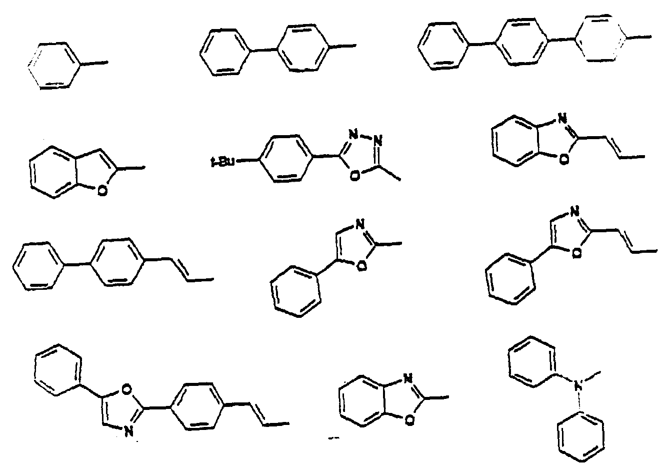
IIIc) K = M et est pris dans le groupe : 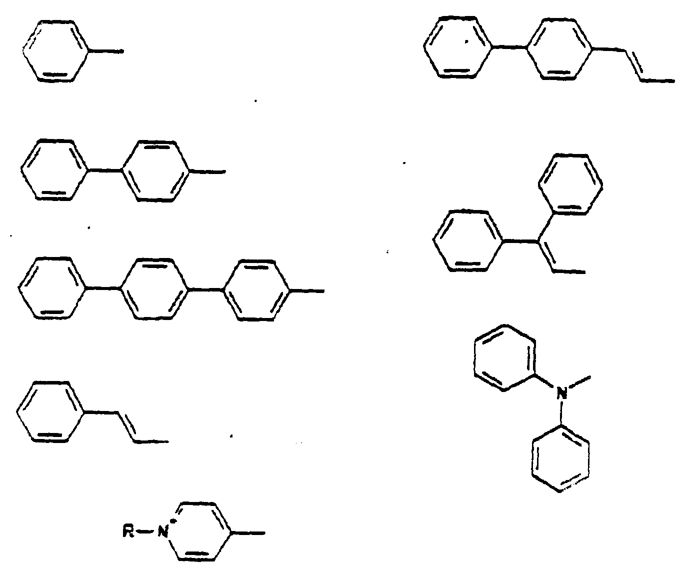 R = alkyle en C₁-C₂₂, (CH₂)ₓ-SO₃⁻ avec x = 2, 3 ou 4
et Q = L et est pris dans le groupe : 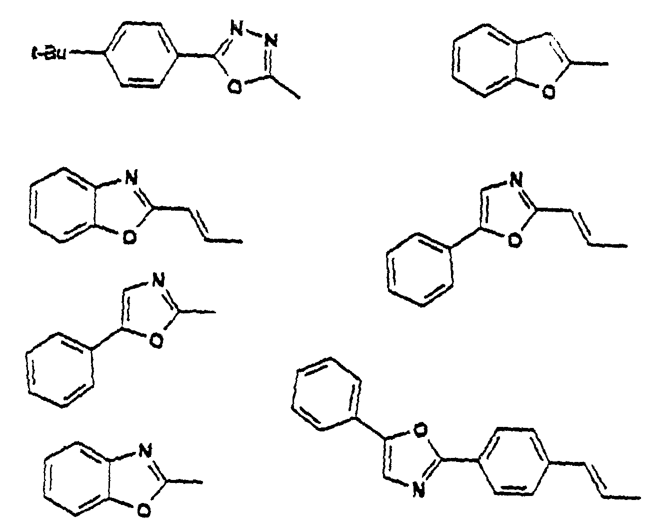
IIId) K = M et est pris dans le groupe : 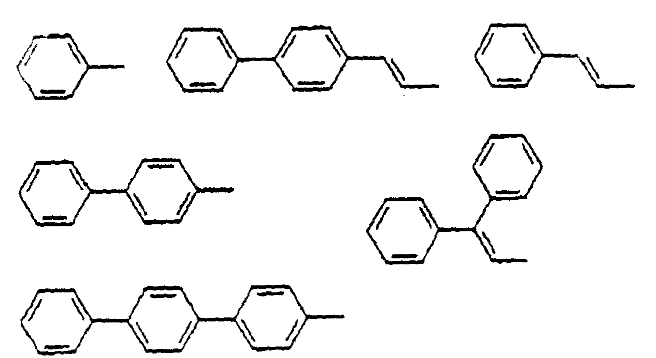 et Q = L et est pris dans le groupe : 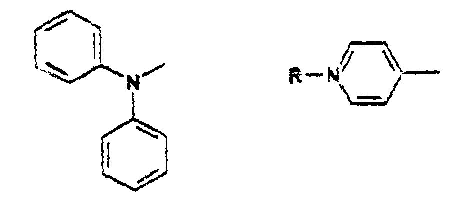 R = alkyle en C₁-C₂₂, (CH₂)ₓ-SO₃⁻ avec x = 2, 3 ou 4
IIIe) K = L = H et M = Q et est pris dans le groupe 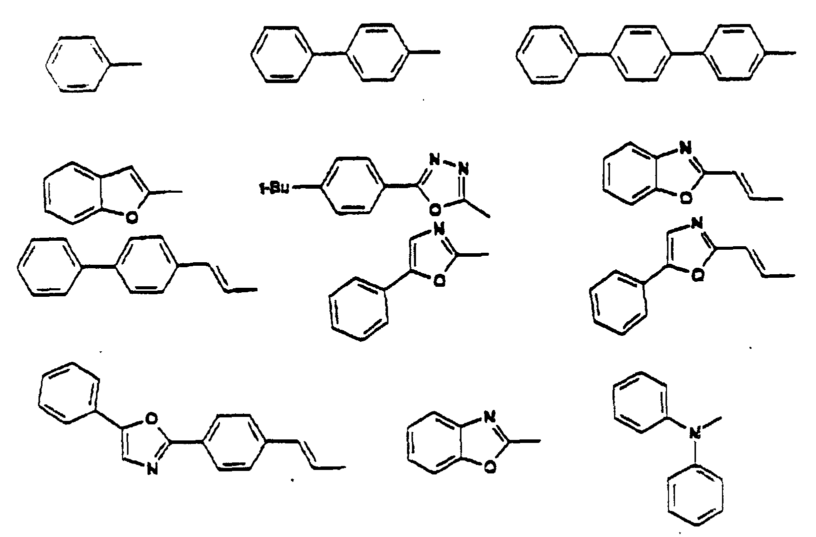
IIIf) K = M et est pris dans le groupe : 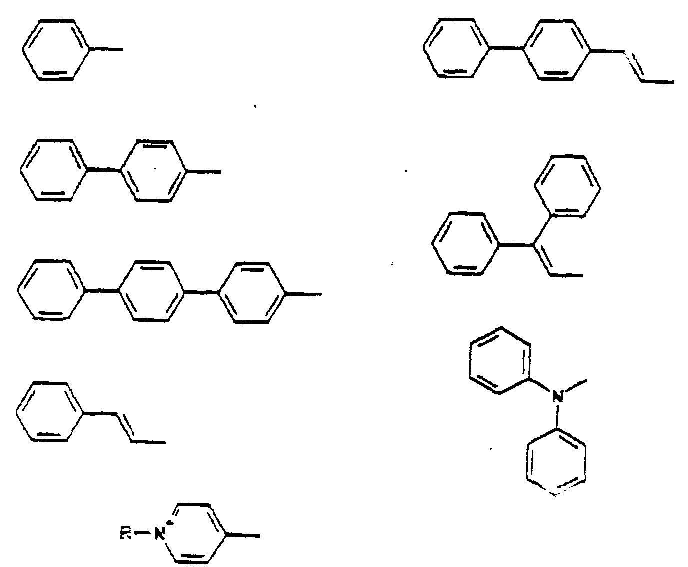 R = alkyle en C₁-C₂₂, (CH₂)ₓ-SO₃ ⁻ avec x = 2, 3 ou 4
et M = Q et est pris dans le groupe : 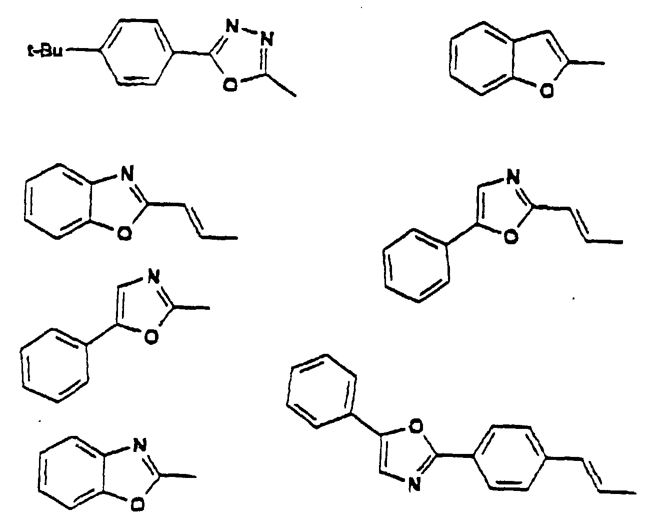
IIIg) K = L et est pris dans le groupe : 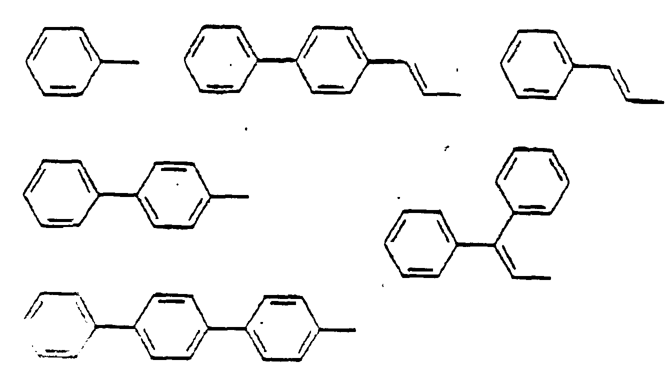 et M = Q et est pris dans le groupe : 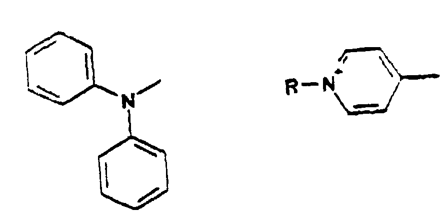 R = alkyle en C₁-C₂₂, (CH₂)x-SO₃⁻ avec x = 2, 3 ou 4

5. Composé héterospiro de formule (IV), 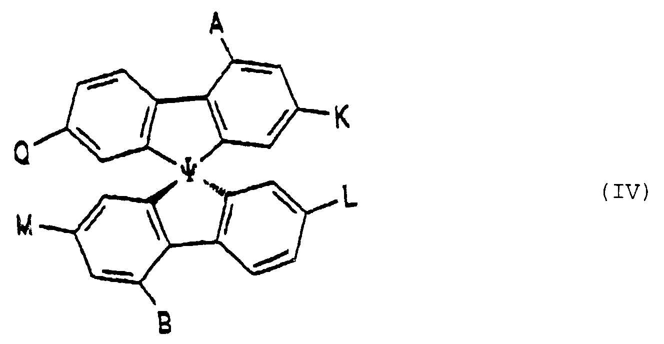 les symboles ayant les significations suivantes :
Ψ représente Si, Ge ou Sn ;
A, B, K, L, M, Q sont identiques ou différents 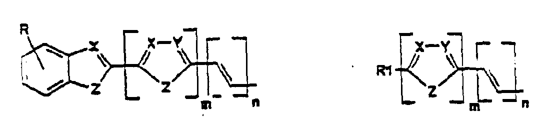 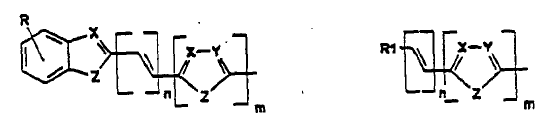 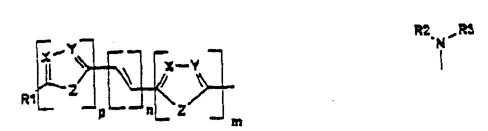
et
A, B peuvent aussi être identiques ou différents et représenter un groupe ester, alcoxy ou alkyle avec de 1 à 22 atomes de carbone, linéaire ou ramifié, -CN, -NO₂, -Ar ou -O-Ar ;
R représente un atome d'hydrogène, un groupe ester, alcoxy ou alkyle avec de 1 à 22 atomes de carbone linéaire ou ramifié, -CN, -NO₂, -NR²R³, -Ar ou -O-Ar ;
Ar représente un groupe phényle, biphényle, 1-naphtyle, 2-naphtyle, 2-thiényle, 2-furanyle, chacun de ces groupes pouvant porter un ou deux restes R ;
m, n, p sont indépendants l'un de l'autre, identiques ou différents et valent 0, 1, 2 ou 3 ;
X, Y identiques ou différents, représentent CR, N ;
Z représente -O-, -S-, -NR¹-, -CR¹R⁴-, -CH=CH-, -CH=N- ;
R¹ et R⁴ sont identiques ou différents et peuvent avoir les mêmes significations que R ;
R², R³ sont identiques ou différents et représentent un groupe alkyle avec de 1 à 22 atomes de carbone, linéaire ou ramifié, -Ar ou un groupe 3-méthylphényle.

6. Utilisation selon une ou plusieurs des revendications 1 à 4, caractérisée en ce que le composé héterospiro sert de couche électroluminescente.

7. Utilisation selon une ou plusieurs des revendications 1 à 4, caractérisée en ce que le composé héterospiro sert de couche de transport.

8. Utilisation selon une ou plusieurs des revendications 1 à 4, caractérisée en ce que le composé héterospiro sert à l'injection de charges.

9. Matière électroluminescente, contenant un ou plusieurs composés héterospiro de formules (I) à (III) dans les revendications 1 à 4.

10. Dispositif à électroluminescence, contenant une couche active, qui contient un ou plusieurs composés hétérospiro de formule (I) à (III) selon une ou plusieurs des revendications 1 à 4.

11. Dispositif électroluminescent selon la revendication 9, caractérisé en ce que la couche active est une couche électroluminescente.

12. Dispositif électroluminescent selon la revendication 9, caractérisé en ce que la couche active est une couche de transport.

13. Dispositif électroluminescent selon la revendication 9, caractérisé en ce que la couche active est une couche d'injection de charge.
